# EUROPEAN PATENT APPLICATION

(11) **EP 4 770 311 A1**
(43) Date of publication of application: **01.07.2026**
(21) Application number: 25226782.8
(22) Date of filing: 23.12.2025
(51) Int. Cl.: H10B 51/10, H10B 51/20, H10B 51/30, H10D 30/01, H10D 30/67, H10D 30/69, H10D 64/01, H10D 64/68, H10D 64/66

(54) **FERROELECTRIC FIELD EFFECT TRANSISTOR, METHOD OF MANUFACTURING FERROELECTRIC FIELD EFFECT TRANSISTOR, MEMORY DEVICE, AND NEURAL NETWORK DEVICE**

(30) Priority: 27.12.2024 KR 20240199345; 02.05.2025 KR 20250058481
(71) Applicant: Samsung Electronics Co., Ltd., Suwon-si, Gyeonggi-do 16677 (KR)
(72) Inventor: Jo, Sanghyun, 16678 Suwon-si, Gyeonggi-do (KR); Choe, Dukhyun, 16678 Suwon-si, Gyeonggi-do (KR); Kim, Sangwook, 16678 Suwon-si, Gyeonggi-do (KR)
(74) Representative: Grünecker Patent- und Rechtsanwälte PartG mbB

(57) **Abstract**

Disclosed are a ferroelectric field effect transistor (100), a method of manufacturing a ferroelectric field effect transistor, a memory device, and a neural network device. The ferroelectric field effect transistor may include: a channel layer (102) including an oxide semiconductor material; a gate electrode (104) facing the channel layer; a ferroelectric layer (103) provided between the channel layer and the gate electrode, the ferroelectric layer including a ferroelectric material; a conductive oxide layer (105) provided between the ferroelectric layer and the gate electrode, conductive oxide layer including a conductive oxide material; and a source electrode (106) and a drain electrode (107) both electrically connected to the channel layer.

## Description

### BACKGROUND

### 1. Field

The disclosure relates to a ferroelectric field effect transistor, a method of manufacturing a ferroelectric field effect transistor, a memory device, and a neural network device.

### 2. Description of the Related Art

Ferroelectrics are materials that exhibit ferroelectricity, in which internal electric dipole moments are aligned and spontaneous polarization may be maintained in the absence of an external electric field. More specifically, in ferroelectrics, even when a certain voltage is applied to a ferroelectric and then the voltage is returned to 0 V, the polarization within the ferroelectric remains semi-permanently. Research on applying these ferroelectric properties to logic devices or memory devices is being continuously performed. For example, in a ferroelectric field effect transistor using a ferroelectric, the threshold voltage of a field effect transistor may vary depending on the direction and strength of polarization within the ferroelectric. Therefore, logic devices and/or memory devices may be implemented by using the threshold voltage change properties of a ferroelectric field effect transistor.

### SUMMARY

Provided are a ferroelectric field effect transistor including an oxide semiconductor channel and having an improved memory window, and a memory device.

The invention is what is claimed in the independent claims. Preferred embodiments are specified in the dependent claims.

Furthermore, provided is a method of manufacturing a ferroelectric field effect transistor.

Furthermore, provided is a neural network device including a ferroelectric field effect transistor.

Additional aspects will be set forth in part in the description which follows and, in part, will be apparent from the description, or may be learned by practice of the presented embodiments of the disclosure.

A ferroelectric field effect transistor according to at least one embodiment includes a channel layer including an oxide semiconductor material; a gate electrode facing the channel layer; a ferroelectric layer between the channel layer and the gate electrode, the ferroelectric layer including a ferroelectric material; a conductive oxide layer between the ferroelectric layer and the gate electrode, the conductive oxide layer including a conductive oxide material; a source electrode electrically connected to the channel layer; and a drain electrode electrically connected to the channel layer.

The conductive oxide material may include, for example, at least one of indium tin oxide (ITO), indium zinc oxide (IZO), indium zinc tin oxide (IZTO), antimony tin oxide (ATO), fluorine doped tin oxide (FTO), or aluminum doped zinc oxide (AZO).

The thickness of the conductive oxide layer in a vertical direction may be less than or equal to the thickness of the gate electrode in the vertical direction.

For example, the thickness of the conductive oxide layer may be greater than or equal to 0.1 nm and less than or equal to 20 nm.

The ferroelectric layer may include a crystalline oxide that includes a first metal and a second metal different from the first metal.

For example, the first metal may include one of Hf or Zr, and the second metal may include at least one of Hf, Zr, La, Si, Al, Y, Ge, and Gd.

The ferroelectric layer may include a first ferroelectric layer and a second ferroelectric layer; the first ferroelectric layer may be between the second ferroelectric layer and the conductive oxide layer and the second ferroelectric layer may be between the channel layer and the first ferroelectric layer.

The first ferroelectric layer may include a crystalline oxide that includes a first metal and a second metal different from the first metal, and the second ferroelectric layer may include only a crystalline oxide of any one of oxide of the first metal and oxide of the second metal.

For example, the first ferroelectric layer may include hafnium zirconium oxide, and the second ferroelectric layer may include one of hafnium oxide and zirconium oxide.

For example, the total thickness of the ferroelectric layer may be greater than or equal to 0.5 nm and less than or equal to 20 nm, and the thickness of the second ferroelectric layer may be greater than or equal to 0.3 nm and less than or equal to 30% of the thickness of the first ferroelectric layer.

For example, the thickness of the second ferroelectric layer may be greater than or equal to 0.3 nm and less than or equal to 3 nm.

The channel layer may include a first channel layer and a second channel layer between the first channel layer and the ferroelectric layer, the first channel layer may include a first oxide semiconductor material, and the second channel layer may include a second oxide semiconductor material different from the first oxide semiconductor material.

In at least one embodiment, the channel layer may include a first surface and a second surface opposite to each other, the source electrode and the drain electrode may be spaced apart from each other on the first surface of the channel layer, and the gate electrode may face the second surface of the channel layer.

In at least one embodiment, the channel layer may include a first surface and a second surface opposite to each other, the gate electrode may face the first surface of the channel layer, the source electrode and the drain electrode may be spaced apart from each other on the first surface of the channel layer, and the ferroelectric layer may be provided on the first surface of the channel layer and at least a portion of the ferroelectric layer may be between the source electrode and the drain electrode.

In at least one embodiment, the channel layer, the ferroelectric layer, the conductive oxide layer, and the gate electrode may extend in a first direction and may be sequentially arranged in a second direction crossing the first direction, and the source electrode and the drain electrode may be spaced apart in the first direction, and are electrically connected to respective end portions of the channel layer in the first direction.

In at least one embodiment, the channel layer may have a cylindrical shape, the ferroelectric layer may surround a circumference of the channel layer, the conductive oxide layer may surround a circumference of the ferroelectric layer, and the gate electrode may surround a circumference of the conductive oxide layer.

A memory device according to at least one embodiment includes a plurality of cell arrays extending in a first direction and two-dimensionally arranged in a second direction and a third direction; a plurality of first conductive lines extending in the second direction; and a plurality of second conductive lines extending in the second direction, the plurality of first conductive lines and/or the plurality of second conductive lines being spaced apart from each other in the first direction and the third direction, wherein each of the plurality of cell arrays comprises a gate electrode extending in the first direction, a conductive oxide layer surrounding the gate electrode, the conductive oxide layer including a conductive oxide material, a ferroelectric layer surrounding the conductive oxide layer, the ferroelectric layer including a ferroelectric material, and a channel layer surrounding the ferroelectric layer, the channel layer including an oxide semiconductor material, and wherein a first side of the channel layer is electrically connected to a corresponding first conductive line of the plurality of first conductive lines and a second side of the channel layer is electrically connected to a corresponding second conductive line of the plurality of second conductive lines.

A method of manufacturing a ferroelectric field effect transistor, according to at least one embodiment, includes forming a channel layer including an oxide semiconductor material, forming a source electrode and a drain electrode on the opposite side edges of the channel layer, forming a ferroelectric precursor layer on the channel layer, forming a conductive oxide layer on the ferroelectric precursor layer, the conductive oxide layer including a conductive oxide material, forming a gate electrode on the conductive oxide layer, and forming a ferroelectric layer by annealing the ferroelectric precursor layer.

A method of manufacturing a ferroelectric field effect transistor, according to at least one embodiment, includes forming a ferroelectric precursor layer, forming a conductive oxide layer on the ferroelectric precursor layer, the conductive oxide layer including a conductive oxide material, forming a gate electrode on the conductive oxide layer, forming a ferroelectric layer by annealing the ferroelectric precursor layer, forming a channel layer on the ferroelectric layer, the channel layer including an oxide semiconductor material, and forming a source electrode and a drain electrode to be electrically connected to the channel layer. The channel layer and the gate electrode may be disposed on different surfaces of the ferroelectric layer. For example, the ferroelectric layer may be provided between the channel layer and the gate electrode.

The annealing of the ferroelectric precursor layer may be performed directly after forming the ferroelectric precursor layer and before forming the conductive oxide layer. The annealing of the ferroelectric precursor layer may be performed after forming the gate electrode, or after forming the ferroelectric precursor layer and before forming the gate electrode. The annealing may be performed two or more times. For example, the annealing may be performed after forming the gate electrode, and after forming the ferroelectric precursor layer and before forming the gate electrode.

The forming of the ferroelectric layer may include forming a second ferroelectric precursor layer by depositing oxide of the first metal, multiple times, by an atomic layer deposition (ALD) method, and forming a first ferroelectric precursor layer by alternately depositing oxide of the first metal and oxide of a second metal, multiple times, by the ALD method, wherein the first ferroelectric precursor layer is provided to be closer to the gate electrode than the second ferroelectric precursor layer is.

A method of manufacturing a ferroelectric field effect transistor, according to at least one embodiment, includes forming a gate electrode, forming a conductive oxide layer on the gate electrode, the conductive oxide layer including a conductive oxide material, forming a ferroelectric precursor layer on the conductive oxide layer, forming a ferroelectric layer by annealing the ferroelectric precursor layer, the ferroelectric layer including a ferroelectric material, forming a channel layer on the ferroelectric layer, the channel layer including an oxide semiconductor material, and forming a source electrode and a drain electrode on the channel layer.

The forming of the ferroelectric precursor layer may include forming a first ferroelectric precursor layer by alternately depositing oxide of a first metal and oxide of a second metal on the conductive oxide layer, multiple times, by the ALD method, and forming a second ferroelectric precursor layer by depositing oxide of the first metal on the first ferroelectric precursor layer, multiple times, by the ALD method, wherein the first ferroelectric precursor layer is provided to be closer to the gate electrode than the second ferroelectric precursor layer is.

A memory device according to at least one embodiment includes a plurality of gate electrodes and a plurality of spacers alternately arranged in a first direction, a channel layer including an oxide semiconductor material and extending in the first direction to be spaced apart from the plurality of gate electrodes and the plurality of spacers in a second direction perpendicular to the first direction, a ferroelectric layer including a ferroelectric material and extending in the first direction between the channel layer and the plurality of gate electrodes and between the channel layer and the plurality of spacers, and a plurality of conductive oxide layers each including conductive oxide material and respectively provided between the ferroelectric layer and the plurality of gate electrodes.

A neural network device according to at least one embodiment includes an array of a plurality of synaptic elements, wherein each of the plurality of synaptic elements includes an access transistor and a ferroelectric field effect transistor, the ferroelectric field effect transistor including a channel layer including an oxide semiconductor material; a gate electrode facing the channel layer; a ferroelectric layer provided between the channel layer and the gate electrode, the ferroelectric layer including a ferroelectric material; a conductive oxide layer provided between the ferroelectric layer and the gate electrode, the conductive oxide layer including a conductive oxide material; and a source electrode and a drain electrode both electrically connected to the channel layer.

A memory device according to at least one embodiment includes a plurality of memory cells two-dimensionally arranged, a plurality of word lines, and a plurality of bit lines, wherein each of the plurality of memory cells includes a ferroelectric field effect transistor, the ferroelectric field effect transistor including a channel layer including an oxide semiconductor material, a gate electrode facing the channel layer, a ferroelectric layer provided between the channel layer and the gate electrode, the ferroelectric layer including a ferroelectric material, a conductive oxide layer provided between the ferroelectric layer and the gate electrode, the conductive oxide layer including a conductive oxide material, and a source electrode and a drain electrode both electrically connected to the channel layer, and wherein a gate electrode of the ferroelectric field effect transistor is electrically connected to a corresponding word line of the plurality of word lines, and a source electrode of the ferroelectric field effect transistor is electrically connected to a corresponding bit line of the plurality of bit lines.

A method of manufacturing a memory device, according to at least one embodiment, includes alternately stacking, in a first direction perpendicular to an upper surface of a substrate, a plurality of insulating layers and a plurality of sacrificial layers on the upper surface of a substrate; forming a plurality of trenches that penetrate the plurality of insulating layers and the plurality of sacrificial layers in the first direction such that the plurality of trenches extend in a second direction perpendicular to the first direction, and are spaced apart from each other in a third direction perpendicular to the first direction and the second direction; forming a plurality of holes that penetrate the plurality of insulating layers and the plurality of sacrificial layers in the first direction, in a mold structure formed between two trenches adjacent to each other; forming a plurality of first recess areas by etching laterally exposed side surfaces of the plurality of sacrificial layers within each hole; sequentially forming a channel layer, a ferroelectric layer, and a conductive oxide layer within the plurality of first recess areas; forming a gate electrode within each of the plurality of holes; forming a plurality of second recess areas by removing the plurality of sacrificial layers to expose a side surface of the channel layer; forming a plurality of first conductive lines and a plurality of second conductive lines by filling the plurality of second recess areas with a conductive material; and forming a plurality of isolation layer by filling the plurality of trenches with an insulating material.

The method of manufacturing a memory device may further include forming a sacrificial pattern in the plurality of trenches before forming the plurality of first recess areas.

The method of manufacturing a memory device may further include removing the sacrificial pattern before forming the plurality of second recess areas.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic cross-sectional view showing a structure of a ferroelectric field effect transistor according to at least one embodiment;
FIGS. 2 and 3 are graphs showing a relationship between a gate voltage pulse width and a memory window (MW) in a ferroelectric field effect transistor according to a comparative example and a ferroelectric field effect transistor according to at least one embodiment;
FIG. 4 is a schematic cross-sectional view showing a structure of a ferroelectric field effect transistor according to at least one embodiment;
FIGS. 5 to 8 are graphs showing operating characteristics of a ferroelectric field effect transistor according to a comparative example and a ferroelectric field effect transistor according to at least one embodiment;
FIGS. 9 and 10 are graphs showing threshold voltages of various ferroelectric field effect transistor samples;
FIGS. 11 and 12 are graphs showing a change in a memory window depending on the thickness of a conductive oxide layer in a ferroelectric field effect transistor according to at least one embodiment;
FIGS. 13 and 14 are graphs showing a relationship between a material of a second ferroelectric layer and a memory window;
FIG. 15 is a graph showing a change in polarization intensity in a first ferroelectric layer according to the number of operations of a ferroelectric field effect transistor;
FIG. 16 is a high angle annular dark field scanning transmission electron microscopy (HAADF-STEM) image of an actually manufactured ferroelectric field effect transistor;
FIG. 17 is a brightfield transmission electron microscopy (BF-TEM) image showing an enlarged rectangular box region in the image of FIG. 16;
FIGS. 18A to 18D are schematic cross-sectional views showing a method of manufacturing the ferroelectric field effect transistor illustrated in FIG. 4, according to at least one embodiment;
FIGS. 19A and 19B are schematic cross-sectional views showing a method of manufacturing the ferroelectric field effect transistor illustrated in FIG. 4, according to at least one embodiment;
FIG. 20 is a BF-TEM image of a ferroelectric field effect transistor manufactured by using aluminum oxide instead of the second ferroelectric layer;
FIGS. 21 and 22 are graphs showing a change in a memory window according to a thickness ratio of the second ferroelectric layer to the first ferroelectric layer;
FIG. 23 is a schematic cross-sectional view showing a structure of a ferroelectric field effect transistor according to at least one embodiment;
FIG. 24 is a schematic cross-sectional view showing a structure of a ferroelectric field effect transistor according to at least one embodiment;
FIG. 25 is a schematic cross-sectional view showing a structure of a ferroelectric field effect transistor according to at least one embodiment;
FIG. 26 is a schematic cross-sectional view showing a structure of a ferroelectric field effect transistor according to at least one embodiment;
FIGS. 27A to 27C are schematic cross-sectional views showing a method of manufacturing the ferroelectric field effect transistor illustrated in FIG. 26, according to at least one embodiment;
FIG. 28 is a schematic cross-sectional view showing a structure of a ferroelectric field effect transistor according to at least one embodiment;
FIG. 29 is a schematic cross-sectional view showing a structure of a ferroelectric field effect transistor according to at least one embodiment;
FIGS. 30 and 31 are schematic vertical and horizontal cross-sectional views, respectively, showing a structure of a ferroelectric field effect transistor according to at least one embodiment;
FIGS. 32 and 33 are schematic horizontal and vertical cross-sectional views, respectively, showing a structure of a memory cell string of a memory device according to at least one embodiment;
FIG. 34 is a schematic vertical cross-sectional view showing a structure of a memory cell string of a memory device according to at least one embodiment;
FIG. 35 is a schematic vertical cross-sectional view showing a structure of a memory cell string of a memory device according to at least one embodiment;
FIG. 36 is an equivalent circuit diagram showing a memory device according to at least one embodiment;
FIG. 37 is a schematic perspective view showing a configuration of a memory device according to at least one embodiment;
FIG. 38 is a plan view of the memory device illustrated in FIG. 37;
FIG. 39 is a schematic cross-sectional view showing a structure of the memory device taken along line I-I' of FIG. 38, according to at least one embodiment;
FIGS. 40A to 40H are schematic cross-sectional views showing a method of manufacturing the memory device illustrated in FIGS. 37 to 39, according to at least one embodiment;
FIG. 41 is a schematic cross-sectional view showing a structure of the memory device taken along line I-I' of FIG. 38, according to at least one embodiment;
FIG. 42 is a schematic circuit diagram a neural network device according to at least one embodiment;
FIG. 43 is a schematic block diagram showing a configuration of an electronic device including a neural network device; and
FIG. 44 is an equivalent circuit diagram of a memory device according to at least one embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a ferroelectric field effect transistor, a memory device, and a neural network device are described in detail with reference to the accompanying drawings. Throughout the drawings, like reference numerals denote like elements, and sizes of components in the drawings may be exaggerated for convenience of explanation, and clarity. Furthermore, as embodiments described below are examples, other modifications may be produced from the embodiments.

When a component is disposed "above" or "on" another component, the component may include not only an element directly contacting on the upper/lower/left/right sides of the other component, but also an element disposed above/under/left/right the other component in a non-contact manner. Additionally, spatially relative terms, such as above, below, etc. are represented herein based on the direction illustrated in the drawings and may be represented otherwise when the orientation of the corresponding object changes. In other words, such spatially relative terms are intended to encompass different orientations of the device in use or operation in addition to the orientation depicted in the figures, such that the device may be otherwise oriented (rotated 90 degrees or at other orientations) and the spatially relative terms used herein interpreted accordingly.

As used herein, the use of the terms "a," "an," "the," and similar referents in the context of describing the disclosure is to be construed to cover both the singular and the plural. More specifically, the singular forms "a," "an," and "the" are intended to include the plural forms as well, unless the context clearly indicates otherwise. It will be further understood that the terms "comprises" and/or "comprising" used herein specify the presence of stated features or elements, but do not preclude the presence or addition of one or more other features or elements.

Also, the operations of all methods described herein can be performed in any suitable order unless otherwise indicated herein or otherwise clearly contradicted by context. The disclosure is not limited to the described order of the steps.

Furthermore, terms such as "... portion," "... unit," "... module," and "... block", and/or terms describing unit configured to perform at least one function or operation may be embodied (and/or included) in processing circuitry, such as hardware, software, or a combination of hardware and software. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc., and/or electronic circuits including said components.

Furthermore, the connecting lines, or connectors shown in the various figures presented are intended to represent functional relationships and/or physical or logical couplings between the various elements. It should be noted that many alternative or additional functional relationships, physical connections or logical connections may be present in a practical device.

The use of any and all examples, or language (e.g., "such as") provided herein, is intended merely to better illuminate the disclosure and does not pose a limitation on the scope of the disclosure unless otherwise claimed. Additionally, when the terms "about" or "substantially" are used in this specification in connection with a numerical value and/or geometric term, it is intended that the associated numerical value includes a manufacturing tolerance (e.g., ±10%) around the stated numerical value. Further, regardless of whether numerical values and/or geometric terms are modified with "about" or "substantially," it will be understood that these values should be construed as including a manufacturing or operational tolerance (e.g., ±10%) around the stated numerical values and/or geometry.

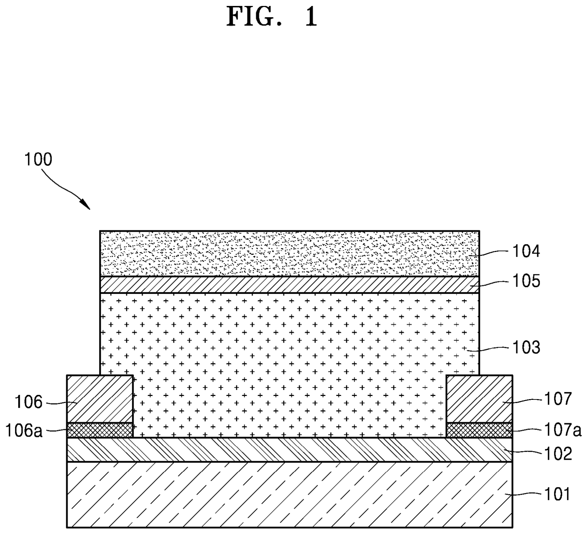

FIG. 1 is a schematic cross-sectional view showing the structure of a ferroelectric field effect transistor 100 according to at least one embodiment. Referring to FIG. 1, the ferroelectric field effect transistor 100 according to at least one embodiment may include a channel layer 102, a ferroelectric layer 103 disposed on an upper surface of the channel layer 102, a gate electrode 104 disposed on an upper surface of the ferroelectric layer 103, a conductive oxide layer 105 provided between the ferroelectric layer 103 and the gate electrode 104, and a source electrode 106 and a drain electrode 107 disposed on the upper surface of the channel layer 102 to face each other on the opposite sides of the ferroelectric layer 103.

The ferroelectric field effect transistor 100 may further include a substrate 101. The channel layer 102 may be disposed on or be included in an upper surface of the substrate 101. The substrate 101 may include, for example, a semiconductor substrate including an elemental semiconductor (e.g., silicon, germanium), and/or a compound semiconductor, or may include an insulating substrate.

The ferroelectric field effect transistor 100 illustrated in FIG. 1 has a top gate structure. In other words, the gate electrode 104 is disposed at the upper portion of the ferroelectric field effect transistor 100. For example, the channel layer 102 may include a first surface (e.g., an upper surface) and a second surface (e.g.., a lower surface) opposite to each other, and the gate electrode 104 may be disposed to face the first surface of the channel layer 102. The ferroelectric layer 103 may be provided between the upper surface (e.g.., the first surface) of the channel layer 102 and a lower surface of the gate electrode 104. The conductive oxide layer 105 may be provided between the ferroelectric layer 103 and the gate electrode 104 above the channel layer 102. Accordingly, the ferroelectric layer 103, the conductive oxide layer 105, and the gate electrode 104 may be sequentially stacked on and above the channel layer 102. As a top gate structure, the source electrode 106 and the drain electrode 107 may be arranged on the same side as the gate electrode 104 with respect to the channel layer 102. In other words, the source electrode 106 and the drain electrode 107, like the gate electrode 104, may be disposed on the first surface (e.g.., the upper surface) of the channel layer 102, facing each other.

The ferroelectric layer 103 may be provided between the source electrode 106 and the drain electrode 107 on the first surface (e.g.., the upper surface) of the channel layer 102. The ferroelectric layer 103 may be or may not be in direct contact with the source electrode 106 or the drain electrode 107. More specifically, although FIG. 1 illustrates that a first side surface of the ferroelectric layer 103 is in contact with the source electrode 106 and that a second side surface of the ferroelectric layer 103, which is opposite to the first side surface, is in contact with the drain electrode 107, the disclosure is not limited thereto. In at least one example embodiment, the source electrode 106 may be spaced apart from the first side surface of the ferroelectric layer 103, and/or the drain electrode 107 may be spaced apart from the second side surface of the ferroelectric layer 103.

In at least some example embodiments, the ferroelectric field effect transistor 100 may further include a first contact layer 106a between the source electrode 106 and the channel layer 102 and/or a second contact layer 107a between the drain electrode 107 and the channel layer 102. The first contact layer 106a and the second contact layer 107a may each be configured to reduce contact resistance between the source electrode 106 and the channel layer 102 and contact resistance between the drain electrode 107 and the channel layer 102. The first contact layer 106a and the second contact layer 107a may each include, for example, indium tin oxide (ITO). However, the disclosure is not limited thereto, and in at least one embodiment, the first contact layer 106a and/or the second contact layer 107a may be omitted.

The channel layer 102 may include an oxide semiconductor material. The oxide semiconductor material may include, for example, an oxide of at least one of metals, such as indium (In), gallium (Ga), zinc (Zn), tungsten (W), and tin (Sn). For example, the channel layer 102 may include at least one of oxide semiconductor materials, such as indium-gallium-zinc oxide (IGZO), indium-zinc oxide (IZO), gallium-zinc oxide (GZO), zinc oxide (ZnO), zinc-tin oxide (ZTO), indium tungsten oxide (IWO), In₂O₃, Ga₂O₃, SnO₂, WO₃, and/or the like. Furthermore, the channel layer 102 may include an oxide semiconductor material doped with an impurity, such as at least one of aluminum (Al), cadmium (Cd), copper (Cu), silicon (Si), zirconium (Zr), magnesium (Mg), and hafnium (Hf). The channel layer 102 may include various other oxide semiconductor materials in addition to the materials described above.

The ferroelectric layer 103 may include a ferroelectric material. Ferroelectrics are materials that exhibit ferroelectricity, in which internal electric dipole moments are aligned and spontaneous polarization is maintained in the absence of an external electric field. The ferroelectric material exhibits spontaneous electric dipoles (spontaneous polarization) due to a non-centrosymmetric charge distribution within unit cells of a crystallized material structure The threshold voltage of the ferroelectric field effect transistor 100 according to at least one embodiment may vary depending on the polarization direction of the ferroelectric layer 103, for example, a direction from the gate electrode 104 to the channel layer 102 or reversely a direction from the channel layer 102 to the gate electrode 104.

For example, the ferroelectric field effect transistor 100 may have a relatively low first threshold voltage and a relatively high second threshold voltage according to the direction and intensity of the polarization in the ferroelectric layer 103. The threshold voltage of the ferroelectric field effect transistor 100 may be a first voltage (e.g., a voltage at which a current flowing between the source electrode 106 and the drain electrode 107 becomes a reference value) or more while a gate voltage applied to the gate electrode 104 is gradually increased. A state in which the ferroelectric field effect transistor 100 has the relatively low first threshold voltage may be referred to as a "Program" state, and a state in which the ferroelectric field effect transistor 100 has the relatively high second threshold voltage may be referred to as an "Erase" state.

The ferroelectric layer 103 may include, for example, hafnium oxide (HfO₂) and zirconium oxide (ZrO₂) in substantially the same metal element ratio (atomic ratio) (e.g., Hf_{0.5}Zr_{0.5}O₂). Alternatively, the ferroelectric layer 103 may include HfO₂ doped with at least one of elements, such as lanthanum (La), silicon (Si), Al, yttrium (Y), gallium (Ga), and/or gadolinium (Gd) at a ratio of less than 10 at%, or ZrO₂ doped with at least one of elements, such as La, Si, Al, Y, Ge, and Gd at a ratio of less than 10 at%. In other words, the ferroelectric layer 103 may include an oxide of a first metal and a second metal different from the first metal. The first metal may include, for example, one of Hf and/or Zr. The second metal may include at least one of Hf, Zr, La, Si, Al, Y, Ge, and/or Gd.

The ferroelectric layer 103 may include a crystal phase. The ferroelectric layer 103 may include any one or more crystal phases of an orthorhombic crystal system, a tetragonal crystal system, and a monoclinic crystal system. For example, the ferroelectric layer 103 may include the orthorhombic crystal system dominantly or in the largest proportion among all crystal phases.

The thickness of the ferroelectric layer 103 may be greater than or equal to 0.5 nanometers (nm) and less than or equal to 20 nm. For example, the thickness of the ferroelectric layer 103 may be about 0.5 nm or more, about 1 nm or more, about 3 nm or more, or about 5 nm or more. The thickness of the ferroelectric layer 103 may be about 20 nm or less, about 15 nm or less, about 10 nm or less, or about 5 nm or less. The thickness of the ferroelectric layer 103 may be greater than or equal to 3 nm and less than or equal to 15 nm.

The gate electrode 104 may include a conductor (e.g., a zero-band gap conductor, and/or a material with a conductive band at the fermi level). For example, the gate electrode 104 may include one or more selected from among a metal, a metal nitride, a metal carbide, polysilicon, and/or a combination thereof. For example, the metal may include Al, W, molybdenum (Mo), titanium (Ti), or tantalum (Ta), the metal nitride may include titanium nitride (TiN) or tantalum nitride (TaN), the metal carbide may include metal carbide doped with (or containing) aluminum or silicon, for example, TiAlC, TaAlC, TiSiC or TaSiC.

The gate electrode 104 may have a structure in which a plurality of materials are stacked. For example, the gate electrode 104 may have a stack structure of metal nitride layer / metal layer, such as TiN/Al, or a stack structure of metal nitride layer / metal carbide layer / metal layer, such as TiN/TiAIC/W. The gate electrode 104 may include titanium nitride (TiN) or Mo, and the above example may be used in various modified forms.

Furthermore, the gate electrode 104 may include conductive two-dimensional materials other than the material described above. For example, the conductive two-dimensional material may include at least one of graphene, black phosphorus, amorphous boron nitride, two-dimensional hexagonal boron nitride (h-BN), and phosphorene.

The ferroelectric field effect transistor 100 according to at least one embodiment, which uses an oxide semiconductor material as the channel layer 102, may have relatively low leakage current properties in an off state and also have a relatively fast operation speed due to high electron mobility of the oxide semiconductor material. Furthermore, as an insulating interface layer that causes unnecessary parasitic capacitance is not naturally formed on the surface of the oxide semiconductor material, a difference between two different threshold voltages of the ferroelectric field effect transistor 100, that is, a memory window that is a difference between the first threshold voltage and the second threshold voltage, may be increased.

The conductive oxide layer 105 may be provided between the ferroelectric layer 103 and the gate electrode 104 to further improve the memory window of the ferroelectric field effect transistor 100. When only the channel layer 102 including the oxide semiconductor material is used, polarization switching in an erase direction may not occur easily in the ferroelectric layer 103 because minority charge carriers (such as holes) hardly exist due to the electron structure and a relatively wide bandgap of the oxide semiconductor material. In view of this problem, the conductive oxide layer 105 provided between the ferroelectric layer 103 and the gate electrode 104 may improve characteristics of the ferroelectric field effect transistor 100 and improve the memory window. The conductive oxide layer 105 may include, for example, at least one conductive oxide material of ITO, IZO, indium zinc tin oxide (IZTO), antimony tin oxide (ATO), fluorine doped tin oxide (FTO), and/or aluminum doped zinc oxide (AZO), but the disclosure is not limited thereto.

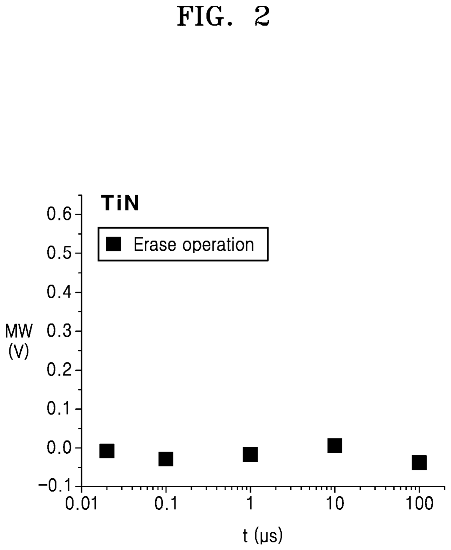

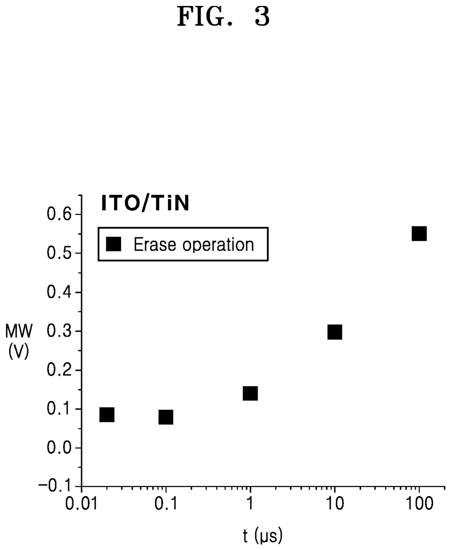

FIGS. 2 and 3 are graphs showing a relationship between a gate voltage pulse width and a memory window in a ferroelectric field effect transistor according to a comparative example (FIG. 2) and a ferroelectric field effect transistor according to at least one embodiment (FIG. 3). In FIGS. 2 and 3, IGZO may be used for the channel layer 102, and Hf_{0.5}Zr_{0.5}O₂ (HZO) may be used for the ferroelectric layer 103. In the comparative example illustrated in FIG. 2, TiN was stacked as the gate electrode 104 directly on the ferroelectric layer 103 without the conductive oxide layer 105. In the example illustrated in FIG. 3, ITO was stacked as the conductive oxide layer 105 on the ferroelectric layer 103, and TiN was stacked as the gate electrode 104 on the conductive oxide layer 105.

Referring to FIG. 2, in the comparative example, after the erase operation, there is almost no difference between the first threshold voltage and the second threshold voltage, and even when the pulse width of the gate voltage for performing the erase operation is increased, the memory window hardly increases. In contrast, referring to FIG. 3, compared with the comparative example, it can be seen that the memory window has been improved. Furthermore, it can be seen that, as the pulse width of the gate voltage for performing an erase operation is increased, the memory window is improved much.

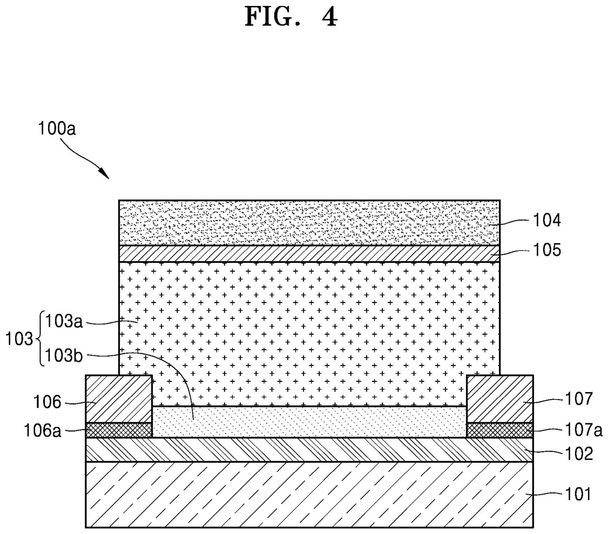

FIG. 4 is a schematic cross-sectional view showing a structure of a ferroelectric field effect transistor 100a according to at least one embodiment. Referring to FIG. 4, the ferroelectric layer 103 of the ferroelectric field effect transistor 100a may include two different ferroelectric layers. For example, the ferroelectric layer 103 may include a first ferroelectric layer 103a adjacent to the conductive oxide layer 105 and a second ferroelectric layer 103b provided between the channel layer 102 and the first ferroelectric layer 103a. Accordingly, the second ferroelectric layer 103b, the first ferroelectric layer 103a, the conductive oxide layer 105, and the gate electrode 104 may be sequentially stacked on and above the channel layer 102. The other components of the ferroelectric field effect transistor 100a illustrated in FIG. 4 may be the same as (and/or substantially similar to) those of the ferroelectric field effect transistor 100 illustrated in FIG. 1.

The first ferroelectric layer 103a may include the same (and/or a substantially similar) ferroelectric material as that of the ferroelectric layer 103 described with reference to FIG. 1. For example, the first ferroelectric layer 103a may include ferroelectric crystals including an oxide of a first metal and a second metal different from the first metal. The first metal may include, for example, one of Hf and Zr. The second metal may include at least one metal different from the first metal among Hf, Zr, La, Si, Al, Y, Ge, and Gd. The first ferroelectric layer 103a may include any one or more crystalline oxides of an orthorhombic crystal system, a tetragonal crystal system, and a monoclinic crystal system. For example, the first ferroelectric layer 103a may include the orthorhombic crystal system dominantly or in the largest proportion among all crystal phases.

The second ferroelectric layer 103b may include ferroelectric crystals that include only one selected from an oxide of the first metal and an oxide of the second metal of the first ferroelectric layer 103a. The second ferroelectric layer 103b may include, for example, ferroelectric crystals of an oxide of one of the same metal as the metals included in the first ferroelectric layer 103a among Hf, Zr, La, Si, Al, Y, Ge, and/or Gd. In other words, when the first ferroelectric layer 103a includes Hf and Zr, the second ferroelectric layer may include only one of Hf or Zr; and when the first ferroelectric layer 103a includes only one of Hf or Zr, the second ferroelectric layer may include a different one of Hf or Zr. For example, when the first ferroelectric layer 103a includes ferroelectric crystals of Hf_{0.5}Zr_{0.5}O₂ (HZO), the second ferroelectric layer 103b may include any one ferroelectric crystal of HfO₂ and ZrO₂. In another example, when the first ferroelectric layer 103a includes HfO₂ doped with at least one of La, Si, Al, Y, Ge, and Gd, the second ferroelectric layer 103b may include any one ferroelectric crystal among oxides of Hf, La, Si, Al, Y, Ge, and/or Gd.

The second ferroelectric layer 103b may include any one or more crystalline oxides of an orthorhombic crystal system, a tetragonal crystal system, and a monoclinic crystal system. For example, the second ferroelectric layer 103b may include the orthorhombic crystal system dominantly or in the largest proportion among all crystal phases. The second ferroelectric layer 103b may include the tetragonal crystal system dominantly or in the largest proportion among all crystal phases. The second ferroelectric layer 103b may further improve the memory window of the ferroelectric field effect transistor 100a.

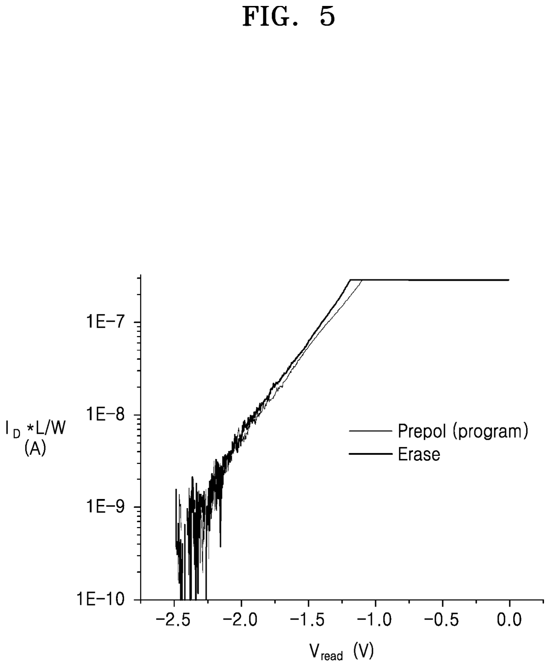

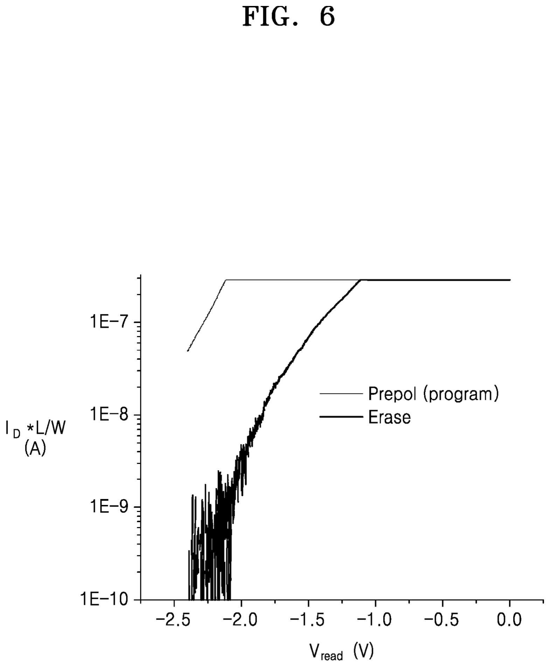

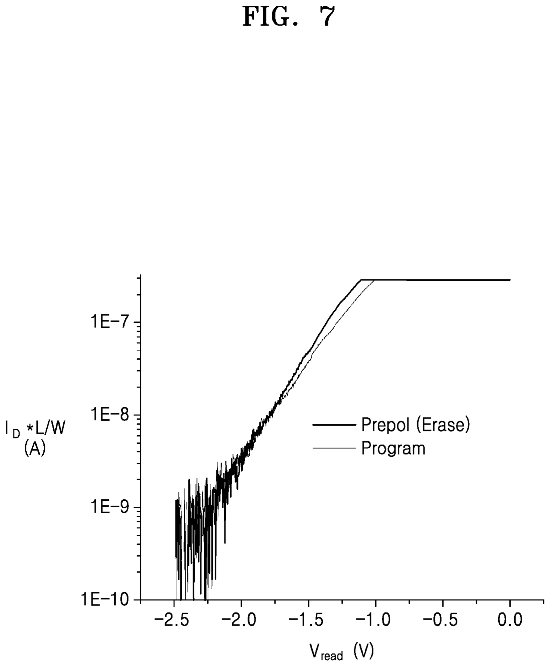

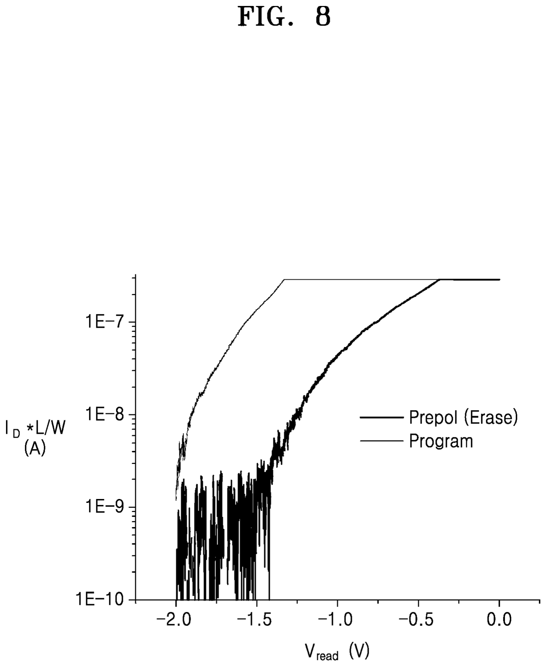

FIGS. 5 to 8 are graphs showing operating characteristics of a ferroelectric field effect transistor according to a comparative example and a ferroelectric field effect transistor according to at least one embodiment. In particular, FIG. 5 illustrates a result of measuring a current flowing between the source electrode and the drain electrode while increasing the gate voltage, after switching the ferroelectric field effect transistor according to the comparative example from the Program state to the Erase state. In FIG. 5, a term 'prepol' means a pre-polarization state or an initial state. FIG. 6 illustrates a result of measuring a current flowing between the source electrode and the drain electrode while increasing the gate voltage, after switching a ferroelectric field effect transistor according to at least one embodiment from the Program state to the Erase state. FIG. 7 illustrates a result of measuring a current flowing between the source electrode and the drain electrode while increasing the gate voltage, after switching the ferroelectric field effect transistor according to the comparative example from the Erase state to the Program state. FIG. 8 illustrates a result of measuring a current flowing between the source electrode and the drain electrode while increasing the gate voltage, after switching the ferroelectric field effect transistor according to at least one embodiment from the Erase state to the Program state. The ferroelectric field effect transistor according to a comparative example does not include the second ferroelectric layer 103b and the conductive oxide layer 105, and uses HZO having a thickness of 8.8 nm as the first ferroelectric layer 103a. The ferroelectric field effect transistor according to at least one embodiment uses HZO having a thickness of 7.7 nm as the first ferroelectric layer 103a, uses HfO₂ having a thickness of 0.9 nm as the second ferroelectric layer 103b, and uses ITO having a thickness of 5 nm as the conductive oxide layer 105. The ferroelectric field effect transistors according to the comparative example and the at least one embodiment use IGZO having a thickness of 10 nm as the channel layer 102 and use Mo having a thickness of 20 nm as the gate electrode 104. Referring to FIGS. 5 and 7, in the comparative example, the first threshold voltage and the second threshold voltage are not clearly distinguished and the memory window is almost close to 0. In contrast, referring to FIGS. 6 and 8, in the embodiment, the first threshold voltage and the second threshold voltage may be clearly distinguished, and the memory window may be increased compared with the comparative example.

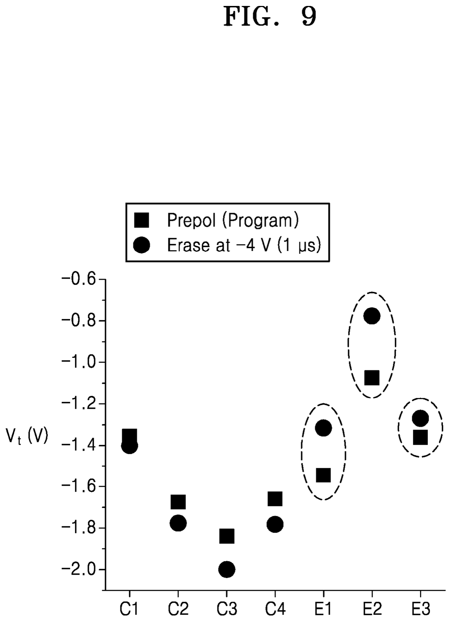

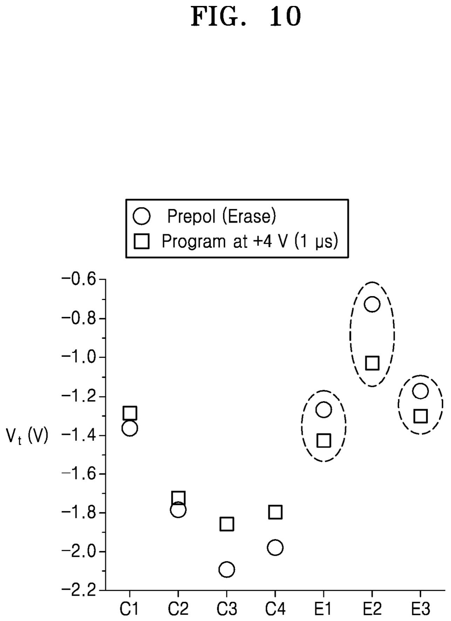

FIGS. 9 and 10 are graphs showing threshold voltages of various ferroelectric field effect transistor samples. In particular, FIG. 9 illustrates the threshold voltages after switching from the Program state to the Erase state. In FIG. 9, solid squares indicate the first threshold voltages in the previous Program state, and solid circles indicate the second threshold voltages in the current Erase state. FIG. 10 illustrates the threshold voltages after switching from the Erase state to the Program state. In FIG. 10, open circles indicate the second threshold voltages in the previous Erase state, and open squares indicate the first threshold voltage in the current Program state. Generally, when the first threshold voltage in the Program state is less than the second threshold voltage in the Erase state, a device operates as a ferroelectric field effect transistor.

Table 1 below schematically shows structures of ferroelectric field effect transistor samples.

**[Table 1]**

| | |
|---|---|
| Comparative Example 1 (C1) | IGZO / HZO (8.8 nm) / Mo |
| Comparative Example 2 (C2) | IGZO / HfO₂ (0.45 nm) / HZO (7.7 nm) / Mo |
| Comparative Example 3 (C3) | IGZO / HZO (7.7 nm) / HfO₂ (0.45 nm) / Mo |
| Comparative Example 4 (C4) | IGZO / HZO (7.7 nm) / HfO₂ (0.9 nm) / Mo |
| Embodiment 1 (E1) | IGZO / HfO₂ (0.45 nm) / HZO (7.7 nm) / ITO (5 nm) / Mo |
| Embodiment 2 (E2) | IGZO / HfO₂ (0.9 nm) / HZO (7.7 nm) / ITO (5 nm) / Mo |
| Embodiment 3 (E3) | IGZO / HZO (8.8 nm) / ITO (5 nm) / Mo |

Comparative Example 1 (C1) does not include the second ferroelectric layer 103b and the conductive oxide layer 105, and uses HZO having a thickness of 8.8 nm as the first ferroelectric layer 103a. Comparative Examples 2-4 (C2-C4) do not include the conductive oxide layer 105. Comparative Example 2 (C2) uses HZO having a thickness of 7.7 nm as the first ferroelectric layer 103a, and uses HfO₂ having a thickness of 0.45 nm as the second ferroelectric layer 103b. In Comparative Example 3 (C3), the order of the first ferroelectric layer 103a and the second ferroelectric layer 103b is opposite to that of Comparative Example 2 (C2). In Comparative Example 4 (C4), the order of the first ferroelectric layer 103a and the second ferroelectric layer 103b is opposite to that of Comparative Example 2 (C2), and HfO₂ having a thickness of 0.9 nm is used as the second ferroelectric layer 103b. Embodiment 1 (E1) uses HZO having a thickness of 7.7 nm as the first ferroelectric layer 103a, uses HfO₂ having a thickness of 0.45 nm as the second ferroelectric layer 103b, and uses ITO having a thickness of 5 nm as the conductive oxide layer 105. Embodiment 2 (E2) uses HZO having a thickness of 7.7 nm as the first ferroelectric layer 103a, uses HfO₂ having a thickness of 0.9 nm as the second ferroelectric layer 103b, and uses ITO having a thickness of 5 nm as the conductive oxide layer 105. Embodiment 3 (E3) does not use the second ferroelectric layer 103b, uses HZO having a thickness of 8.8 nm as the first ferroelectric layer 103a, and uses ITO having a thickness of 5 nm as the conductive oxide layer 105. Accordingly, Embodiments 1 and 2 (E1 and E2) correspond to the embodiment illustrated in FIG. 4, and Embodiment 3 (E3) corresponds to the embodiment illustrated in FIG. 1. In Comparative Examples 1-4 (C1-C4) and Embodiments 1-3 (E1-E3), IGZO has a thickness of 10 nm and Mo has a thickness of 20 nm.

Referring to FIG. 9, after applying a gate voltage of -4 V with a pulse width of 1 µs to samples in the Program state to be switched to the Erase state, the samples that show the operating characteristics of a field effect transistor in which the second threshold voltage is higher than the first threshold voltage are merely Embodiments 1 to 3 (E1 to E3).

Referring to FIG. 10, after applying a gate voltage of +4 V with a pulse width of 1 µs to samples in the Erase state to be switched to the Program state, the samples that show the operating characteristics of a field effect transistor in which the second threshold voltage is higher than the first threshold voltage are merely Embodiments 1 to 3 (E1 to E3).

Accordingly, it can be seen that normal operating characteristics of a ferroelectric field effect transistor are shown only in the samples according to embodiments. Furthermore, it can be seen that a case of further including HfO₂ that is the second ferroelectric layer 103b (Embodiments 1 and 2 (E1 and E2)) shows a larger memory window than a case of not including the second ferroelectric layer 103b.

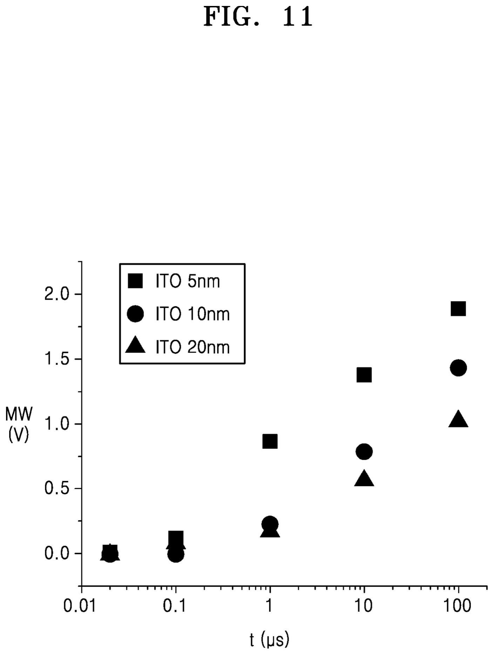

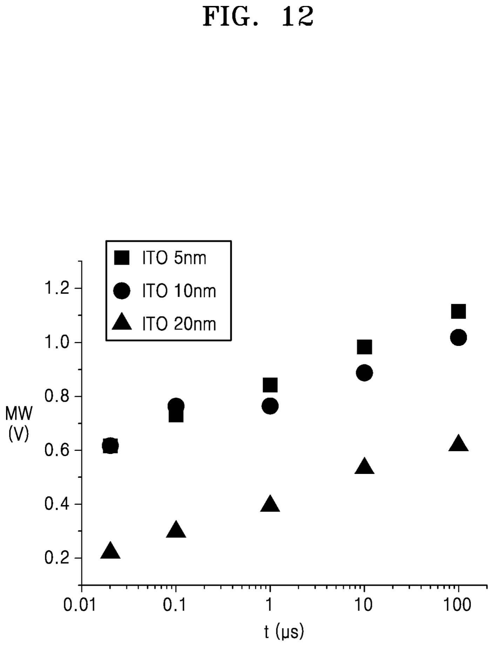

FIGS. 11 and 12 are graphs showing a change in a memory window depending on the thickness of the conductive oxide layer 15 in a ferroelectric field effect transistor according to at least one embodiment. In FIGS. 11 and 12, samples use IGZO having a thickness of 10 nm as the channel layer 102, use Mo having a thickness of 20 nm as the gate electrode 104, use HZO having a thickness of 7.7 nm as the first ferroelectric layer 103a, uses HfO₂ having a thickness of 0.9 nm as the second ferroelectric layer 103b, and use ITO as the conductive oxide layer 105. Furthermore, FIG. 11 illustrates the memory window after switching from the Program state to the Erase state, and FIG. 12 illustrates the memory window after switching from the Erase state to the Program state. In FIGS. 11 and 12, the horizontal axis indicates the pulse width of a gate voltage. Referring to FIGS. 11 and 12, as the thickness of the conductive oxide layer 105 increases from 5 nm to 10 nm and 20 nm, the memory window may become small. In consideration of the point, the thickness of the conductive oxide layer 105 does not need to be excessively thick. The thickness of the conductive oxide layer 105 may be less than or equal to the thickness of the gate electrode 104. For example, the thickness of the conductive oxide layer 105 may be 100% or less, about 75% or less, about 50% or less, about 30% or less, or about 25% or less of the thickness of the gate electrode 104. For example, the thickness of the conductive oxide layer 105 may be about 0.1 nm or more, about 0.5 nm or more, or about 1 nm or more. For example, the thickness of the conductive oxide layer 105 may be about 20 nm or less, about 10 nm or less, about 7 nm or less, or about 5 nm or less.

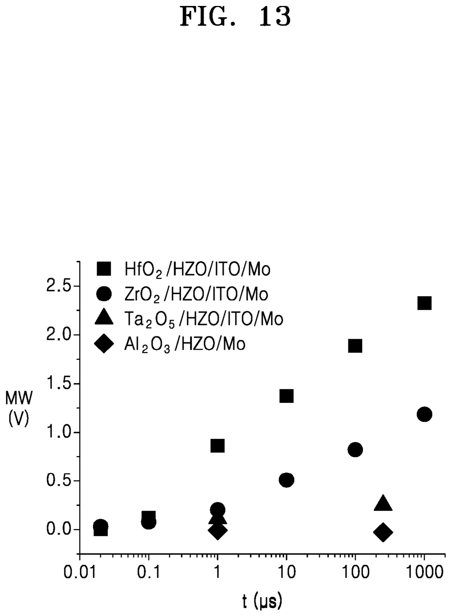

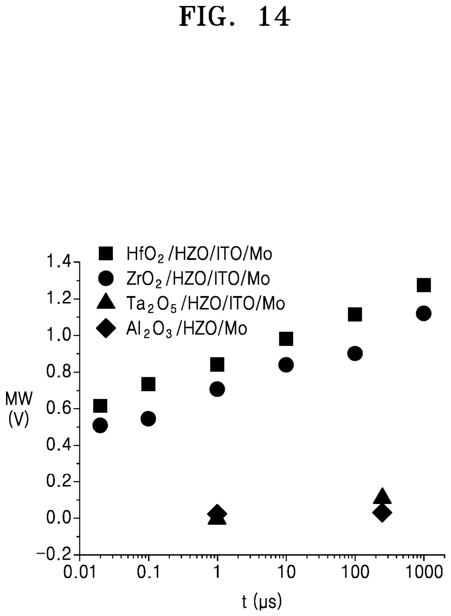

FIGS. 13 and 14 are graphs showing a relationship between a material of the second ferroelectric layer 103b and the memory window. In FIGS. 13 and 14, samples use IGZO having a thickness of 9 nm as the channel layer 102, use Mo having a thickness of 20 nm as the gate electrode 104, use HZO as the first ferroelectric layer 103a, and use ITO having a thickness of 1 nm as the conductive oxide layer 105. In FIGS. 13 and 14, HfO₂ and ZrO₂ were deposited to a thickness of about 0.92 nm by an atomic layer deposition (ALD) method, HZO was deposited to a thickness of about 7.7 nm by the ALD method, tantalum oxide (Ta₂O₅) was deposited to a thickness of about 1 nm by the ALD method, and aluminum oxide (Al₂O₃) was deposited to a thickness of about 0.5 nm by the ALD method.

Furthermore, FIG. 13 illustrates the memory window after switching from the Program state to the Erase state, and FIG. 14 illustrates the memory window after switching from the Erase state to the Program state. In FIGS. 13 and 14, the horizontal axis indicates the pulse width of the gate voltage. Referring to FIGS. 13 and 14, when the second ferroelectric layer 103b includes a crystalline ferroelectric material, such as HfO₂ or ZrO₂, a sufficiently large memory window may be obtained. In contrast, when the second ferroelectric layer 103b includes an amorphous paraelectric material, such as Ta₂O₅ or Al₂O₃, it may be difficult to secure a sufficient memory window.

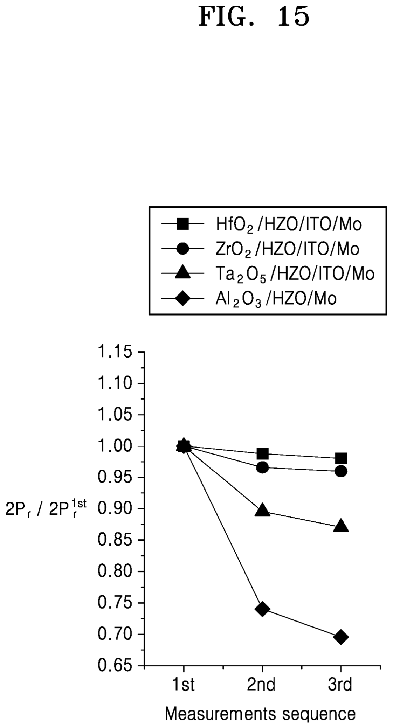

FIG. 15 is a graph showing a change in polarization intensity in the first ferroelectric layer 103a according to the number of operations of a ferroelectric field effect transistor. In FIG. 15, 2Pᵣ denotes a difference between first polarization in the first ferroelectric layer 103a when a positive (+) gate voltage is applied to the gate electrode 104 and second polarization in the first ferroelectric layer 103a when a negative (-) gate voltage is applied to the gate electrode 104. As the first polarization and the second polarization are opposite directions, 2Pᵣ may be the sum of the absolute value of the intensity of the first polarization and the absolute value of the intensity of the second polarization. In FIG. 15, the vertical axis indicates a value obtained by dividing the current 2Pᵣ value by the 2Pᵣ value at the initial operation (2Pᵣ^{1st}), and the horizontal axis indicates the frequency of applications of the gate voltage. In FIG. 15, HfO₂ and ZrO₂ were deposited to a thickness of 0.92 nm by the ALD method, HZO was deposited to a thickness of 7.7 nm by the ALD method, Ta₂O₅ was deposited to a thickness of 1 nm by the ALD method, and Al₂O₃ was deposited to a thickness of 0.5 nm by the ALD method. In addition, IGZO having a thickness of 9 nm was used as the channel layer 102, Mo having a thickness of 20 nm was used as the gate electrode 104, and ITO having a thickness of 1 nm was used as the conductive oxide layer 105.

Referring to FIG. 15, in a case where the second ferroelectric layer 103b includes a crystalline ferroelectric material, such as HfO₂ or ZrO₂, even when the number of operations increases, the intensity of polarization in the first ferroelectric layer 103a is hardly changed. In contrast, when the second ferroelectric layer 103b includes an amorphous paraelectric material, such as Ta₂O₅ or Al₂O₃, the intensity of polarization in the first ferroelectric layer 103a decreases as the number of operations increases. Such phenomena may be due to the remnant polarization that remains in the Program state without polarization switching within the first ferroelectric layer 103a after the erase operation. According to at least one embodiment, by using the second ferroelectric layer 103b including ferroelectric crystals and the conductive oxide layer 105 together, the remnant polarization in the first ferroelectric layer 103a may be reduced.

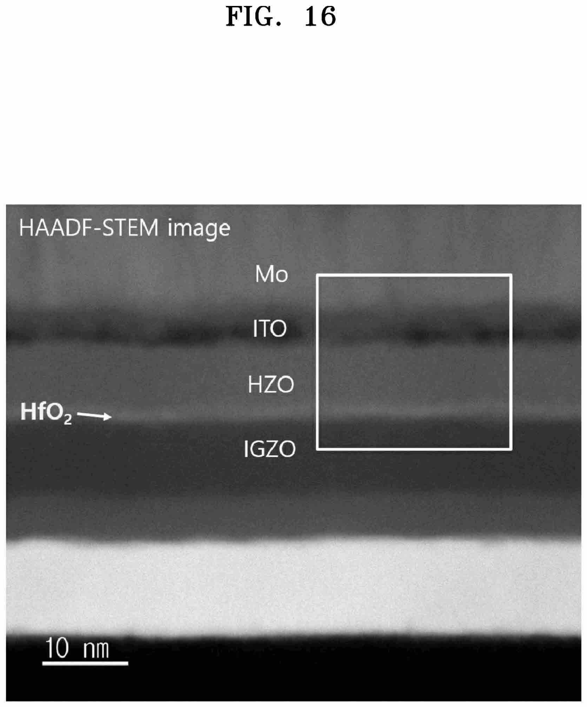

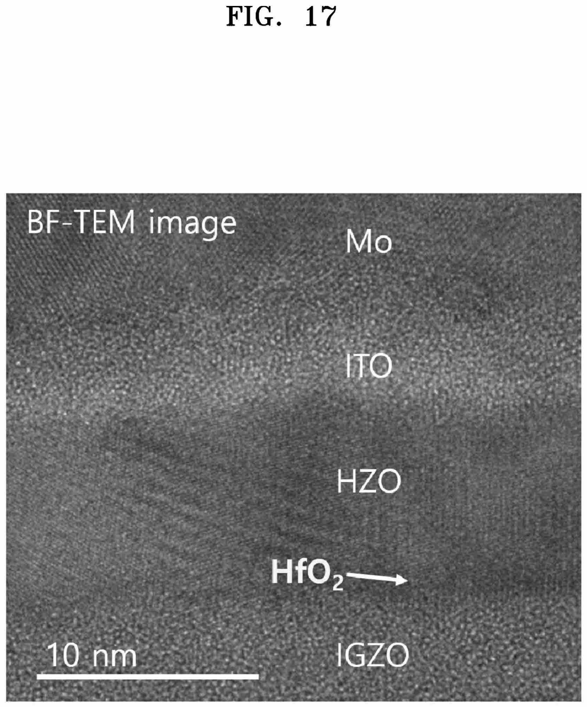

FIG. 16 is a high angle annular dark field scanning transmission electron microscopy (HAADF-STEM) image of an actually manufactured ferroelectric field effect transistor. FIG. 17 is a bright field transmission electron microscopy (BF-TEM) image showing an enlarged rectangular box region in the image of FIG. 16. Referring to FIG. 16, HfO₂ that is the second ferroelectric layer 103b is clearly shown between the IGZO of the channel layer 102 and the HZO of the first ferroelectric layer 103a. Also, referring to FIG. 17, the HfO₂ is shown as being crystalized together with the HZO of the first ferroelectric layer 103a.

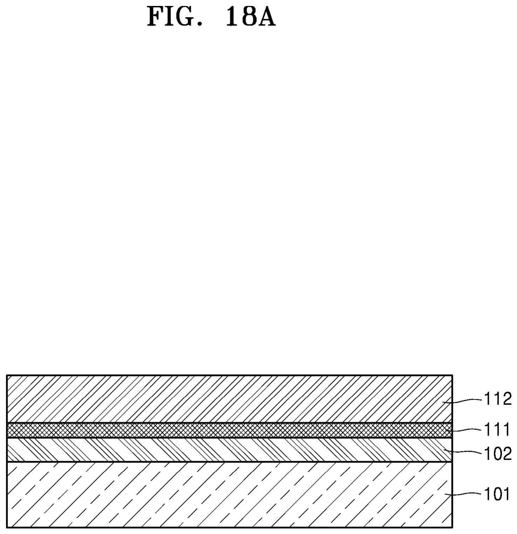

According to at least one embodiment, in a process of manufacturing the ferroelectric field effect transistor 100a, an annealing may be performed to crystalize the first ferroelectric layer 103a and the second ferroelectric layer 103b. FIGS. 18A to 18D are schematic cross-sectional views showing a method of manufacturing the ferroelectric field effect transistor 100a illustrated in FIG. 4, according to at least one embodiment.

Referring to FIG. 18A, after forming a channel layer 102 including an oxide semiconductor material on a substrate 101, a contact material layer 111 and an electrode material layer 112 may be sequentially formed on and above the channel layer 102.

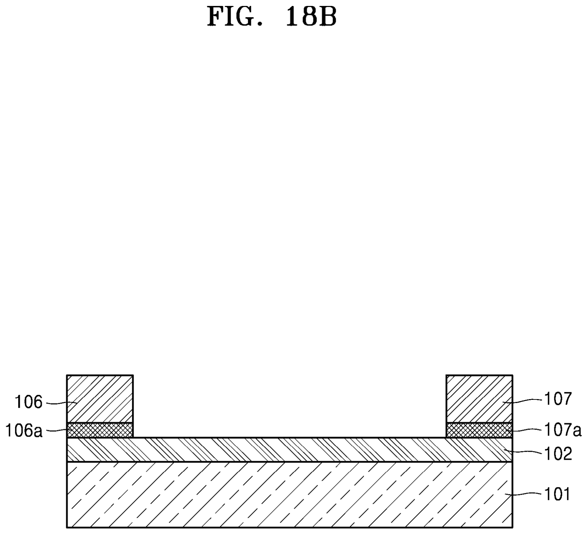

Referring to FIG. 18B, in order to expose the center portion of the channel layer 102, the contact material layer 111 and the electrode material layer 112 provided in the center portion of the channel layer 102 may be etched and completely removed. Thereby, the first contact layer 106a and the second contact layer 107a may be spaced apart from each other on the opposite side edges of the channel layer 102. Furthermore, the source electrode 106 and the drain electrode 107 may be spaced apart from each other on the opposite side edges of the channel layer 102.

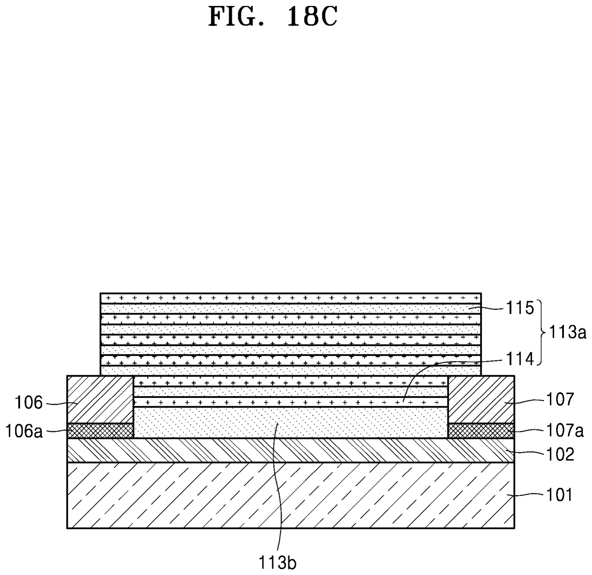

Referring to FIG. 18C, the material layer of the second ferroelectric layer 103b, for example, a second ferroelectric precursor layer 113b, may be formed on the channel layer 102 between the source electrode 106 and the drain electrode 107, and the material layer of the first ferroelectric layer 103a, for example, a first ferroelectric precursor layer 113a, may be formed on the second ferroelectric precursor layer 113b. The second ferroelectric precursor layer 113b and the first ferroelectric precursor layer 113a may be formed by, for example, the ALD method.

When the second ferroelectric layer 103b includes the oxide of the first metal and the first ferroelectric layer 103a includes the oxide of the first metal and the oxide of the second metal, the second ferroelectric precursor layer 113b may be formed by depositing the oxide of the first metal, multiple times, by the ALD method. Then, the first ferroelectric precursor layer 113a may be formed by alternately depositing a first metal oxide layer 114 including the oxide of the first metal and a second metal oxide layer 115 including the oxide of the second metal on the second ferroelectric precursor layer 113b, multiple times, by the ALD method.

FIG. 18C illustrates that the first metal oxide layer 114 is first deposited on the second ferroelectric precursor layer 113b, but the disclosure is not limited thereto. For example, the second metal oxide layer 115 may be first deposited on the second ferroelectric precursor layer 113b. Also, FIG. 18C illustrates that the first metal oxide layer 114 is located at the top portion of the first ferroelectric precursor layer 113a, but the disclosure is not limited thereto. For example, the second metal oxide layer 115 may be located at the top portion of the first ferroelectric precursor layer 113a. In other words, any one of the first metal oxide layer 114 and the second metal oxide layer 115 may be first deposited, and then, any one of the first metal oxide layer 114 and the second metal oxide layer 115 may be finally deposited. The total number of the first metal oxide layer 114 and the second metal oxide layer 115 may be even or odd.

For example, when the first ferroelectric layer 103a includes HZO and the second ferroelectric layer 103b includes HfO₂, the second ferroelectric precursor layer 113b may be formed by depositing HfO₂ multiple times by the ALD method. Then, the first ferroelectric precursor layer 113a may be formed by alternately depositing HfO₂ and ZrO₂ multiple times by the ALD method. When forming the first ferroelectric precursor layer 113a, any one of HfO₂ and ZrO₂ may be first deposited, and any one of HfO₂ and ZrO₂ may be finally deposited.

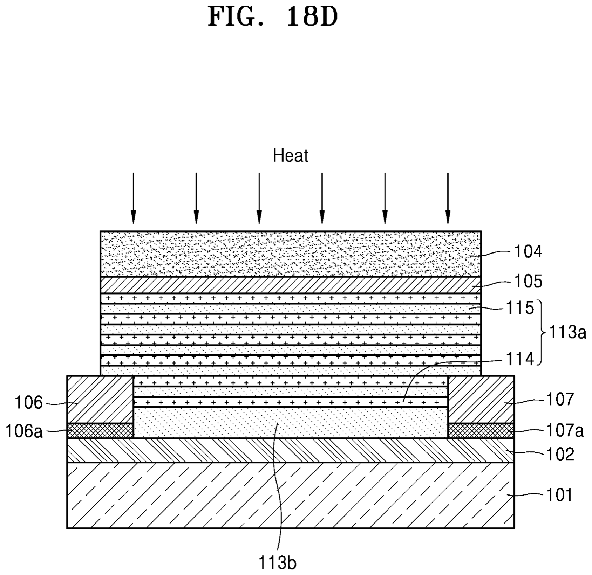

Referring to FIG. 18D, the conductive oxide layer 105 may be formed on the first ferroelectric precursor layer 113a, and then the gate electrode 104 may be formed on the conductive oxide layer 105. Accordingly, the first ferroelectric precursor layer 113a may be positioned closer to the gate electrode 104 than the second ferroelectric precursor layer 113b is. Then, through annealing to a temperature of about 400°C, or lower or higher, the first ferroelectric precursor layer 113a and the second ferroelectric precursor layer 113b are crystallized so that each of the first ferroelectric layer 103a and the second ferroelectric layer 103b may be formed. For example, an annealing temperature for crystallization may be about 350°C or more, about 400°C or more, about 450°C or more, or about 500°C or more and/or about 700°C or less or about 600°C or less. Then, the ferroelectric layer 103 including the first ferroelectric layer 103a and the second ferroelectric layer 103b may be formed on the channel layer 102.

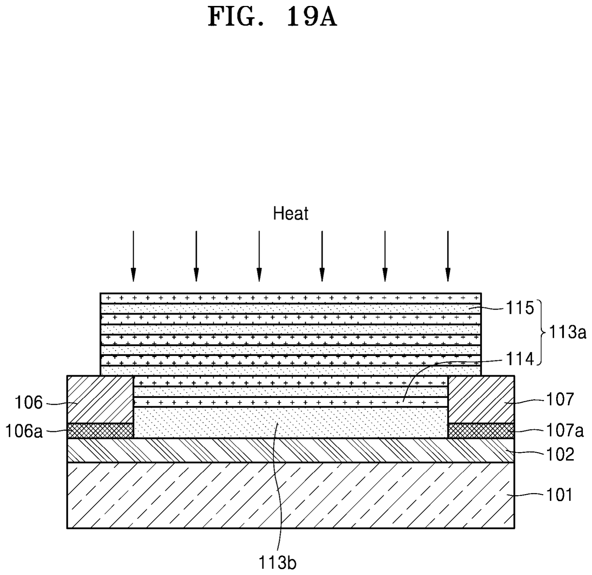

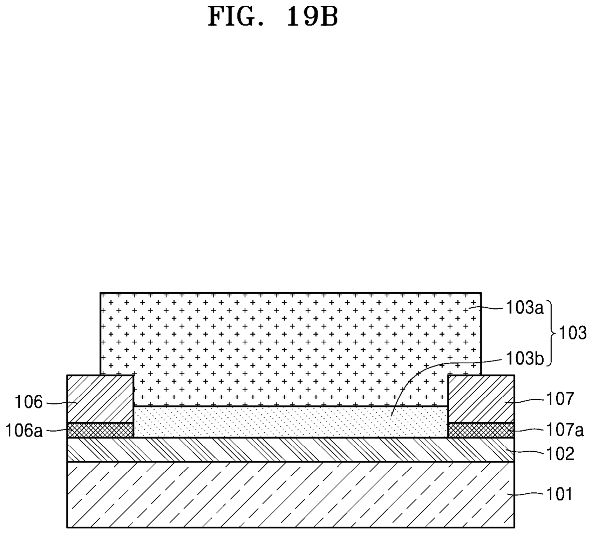

FIGS. 19A and 19B are schematic cross-sectional views showing a method of manufacturing the ferroelectric field effect transistor 100a illustrated in FIG. 4, according to at least one embodiment.

Referring to FIG. 19A, in at least one embodiment, directly after sequentially stacking the second ferroelectric precursor layer 113b and the first ferroelectric precursor layer 113a on and above the channel layer 102 by the ALD method, annealing may be first performed before forming the conductive oxide layer 105 and the gate electrode 104.

Then, as illustrated in FIG. 19B, as the first ferroelectric precursor layer 113a and the second ferroelectric precursor layer 113b are crystallized, the first ferroelectric layer 103a and the second ferroelectric layer 103b may be formed earlier than the conductive oxide layer 105 and the gate electrode 104.

Then, the conductive oxide layer 105 and the gate electrode 104 may be sequentially stacked on and above the first ferroelectric layer 103a that is crystallized.

In at least one embodiment, annealing may be performed two or more times. For example, as illustrated in FIG. 19A, annealing may be first performed before forming the conductive oxide layer 105 and the gate electrode 104, and next, as illustrated in FIG. 18D, annealing may be performed again after forming the conductive oxide layer 105 and the gate electrode 104. In other words, annealing may be performed both after forming the first ferroelectric precursor layer 113a and the second ferroelectric precursor layer 113b and after forming the conductive oxide layer 105 and the gate electrode 104.

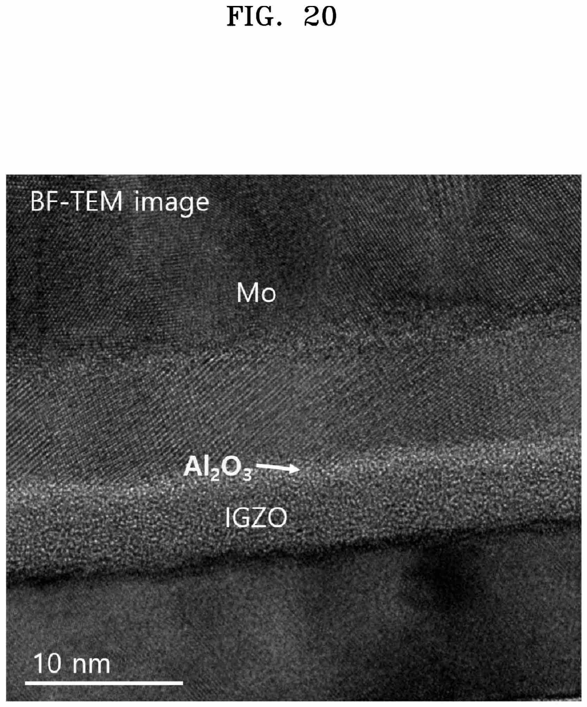

FIG. 20 is a BF-TEM image of a ferroelectric field effect transistor manufactured by using Al₂O₃ instead of the second ferroelectric layer 103b. Referring to FIG. 20, even after the first ferroelectric layer 103a is crystallized, Al₂O₃ remains in an amorphous state. Accordingly, when the second ferroelectric layer 103b includes other material than the ferroelectric material according to at least one embodiment, the second ferroelectric layer 103b may be relatively difficult to be crystallized together with the first ferroelectric layer 103a.

As for the ferroelectric field effect transistor including a material that is not crystallized to ferroelectric and exhibits amorphous paraelectric properties even after annealing, as illustrated in FIG. 20, it may be difficult to secure sufficient memory window and as the number of operations increases, performance may deteriorate, as illustrated in FIGS. 13 to 15. In contrast, as for the ferroelectric field effect transistor including the second ferroelectric layer 103b including a material that is crystallized with the first ferroelectric layer 103a to ferroelectric after annealing, as illustrated in FIG. 17, a sufficient memory window may be obtained and even as the number of operations increases, performance may hardly deteriorate, as illustrated in FIGS. 13 to 15.

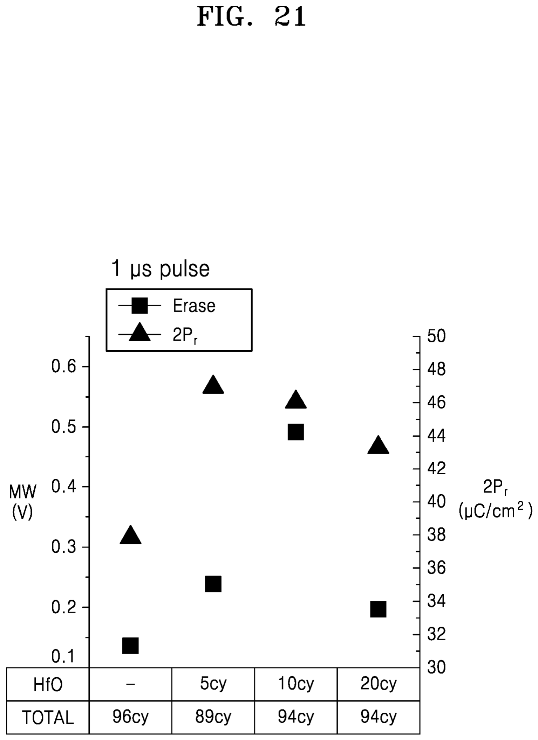

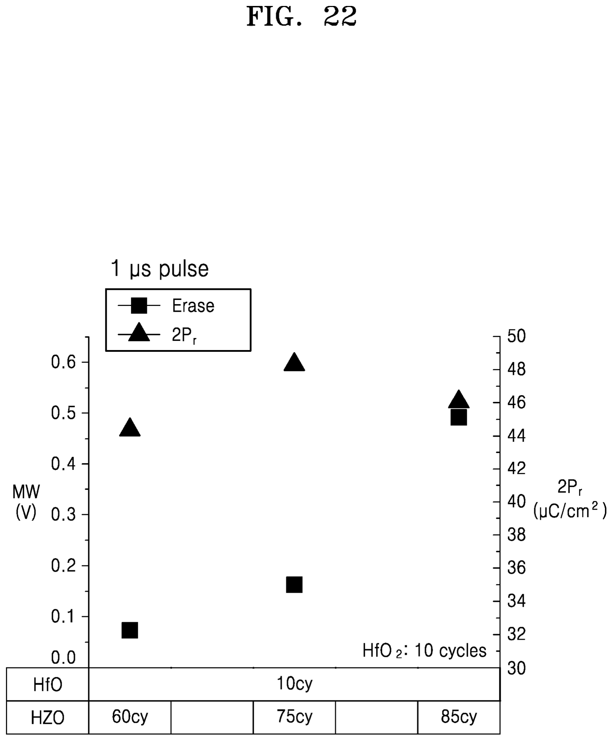

FIGS. 21 and 22 are graphs showing a change in a memory window according to a thickness ratio of the second ferroelectric layer 103b to the first ferroelectric layer 103a. In FIG. 21, the horizontal axis indicates the number of depositions of HfO₂ (represented as HfO in the figures) of the second ferroelectric layer 103b by the ALD method and the total number of atomic layer depositions of the first ferroelectric layer 103a and the second ferroelectric layer 103b, the left vertical axis indicates the memory window, and the right vertical axis indicates the intensity 2Pᵣ of polarization in the first ferroelectric layer 103a. In the example of FIG. 21, when the number of atomic layer depositions of the second ferroelectric layer 103b is 0 cycles (thickness: 0 nm), 5 cycles (thickness: 0.46 nm), 10 cycles (thickness: 0.92 nm), and 20 cycles (thickness: 1.83 nm), the total number of atomic layer depositions of the first ferroelectric layer 103a and the second ferroelectric layer 103b each is 96 cycles (thickness: 8.7 nm), 89 cycles (thickness: 8.16 nm), 94 cycles (thickness: 8.62 nm), and 94 cycles (thickness: 8.62 nm). Referring to FIG. 21, when the number of atomic layer depositions of the second ferroelectric layer 103b is 10 cycles (thickness: 0.92 nm) (totally 94 cycles (thickness: 8.62 nm)), the largest memory window may be obtained.

In FIG. 22, the horizontal axis indicates the number of atomic layer depositions of HZO of the first ferroelectric layer 103a. In the example of FIG. 22, the HZO of the first ferroelectric layer 103a is stacked 60 cycles (thickness: 5.5 nm), 75 cycles (thickness: 6.9 nm), and 85 cycles (thickness: 7.8 nm) by the ALD method. The number of atomic layer depositions of HfO₂ of the second ferroelectric layer 103b is fixed to 10 cycles (thickness: 0.92 nm). Referring to FIG. 22, when the number of atomic layer depositions of the first ferroelectric layer 103a is 85 cycles (thickness: 7.8 nm), the largest memory window may be obtained. Accordingly, considering the results of FIGS. 21 and 22, in the case of including both of the first ferroelectric layer 103a and the second ferroelectric layer 103b, polarization intensity 2Pᵣ may be high and the memory window may be large. Furthermore, it may be advantageous that the second ferroelectric layer 103b has an appropriate thickness. For example, the minimum thickness of the second ferroelectric layer 103b may be greater than or equal to 0.3 nm, and the maximum thickness of the second ferroelectric layer 103b may be exceeding 0%, about 3% or more, about 5% or more, or about 10% or more and about 30% or less, about 20% or less, or about 15% or less of the thickness of the first ferroelectric layer 103a. The total thickness of the ferroelectric layer 103 including the first ferroelectric layer 103a and the second ferroelectric layer 103b may be greater than or equal to 0.5 nm and less than or equal to 20 nm. The thickness of the second ferroelectric layer 103b may be, for example, 0.3 nm or more and 3 nm or less, 2 nm or less, or 1 nm or less.

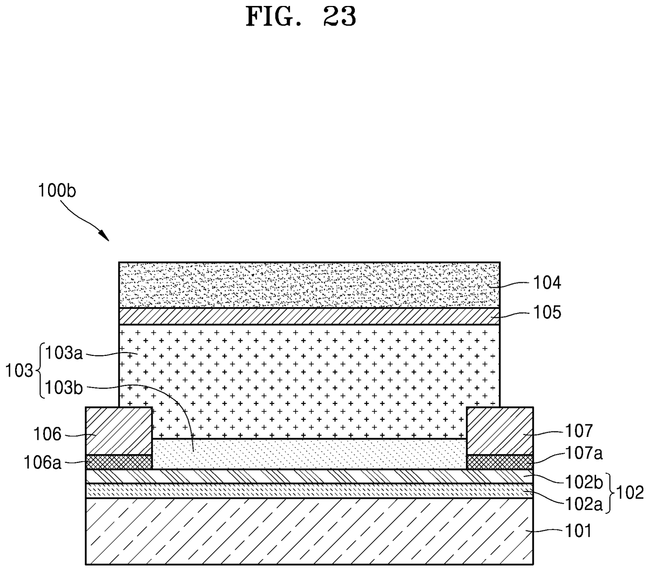

FIG. 23 is a schematic cross-sectional view showing a structure of a ferroelectric field effect transistor 100b according to at least one embodiment. Referring to FIG. 23, the channel layer 102 of the ferroelectric field effect transistor 100b according to at least one embodiment may have a multilayer structure. For example, the channel layer 102 may include a first channel layer 102a and a second channel layer 102b. The first channel layer 102a may be disposed on the substrate 101, and the second channel layer 102b may be disposed on the first channel layer 102a. In this case, the ferroelectric layer 103, in particular the second ferroelectric layer 103b may be disposed on the second channel layer 102b. In other words, the second channel layer 102b may be provided between the first channel layer 102a and the ferroelectric layer 103, or between the first channel layer 102a and the second ferroelectric layer 103b.

The first channel layer 102a may include a first oxide semiconductor material, and the second channel layer 102b may include a second oxide semiconductor material different from the first oxide semiconductor material. For example, the first channel layer 102a may include at least one oxide semiconductor material of IGZO, IZO, GZO, ZnO, ZTO, IWO, In₂O₃, Ga₂O₃, SnO₂, and WO₃. The second channel layer 102b may include at least one oxide semiconductor material of IGZO, IZO, GZO, ZnO, ZTO, IWO, In₂O₃, Ga₂O₃, SnO₂, and WO₃, which is different from the material of the first channel layer 102a. The other components of the ferroelectric field effect transistor 100b illustrated in FIG. 23 may be the same as (and/or substantially similar to) those of the ferroelectric field effect transistor 100a illustrated in FIG. 4. Furthermore, the channel layer 102 in a multilayer structure illustrated in FIG. 23 may be applied to the ferroelectric field effect transistor 100 illustrated in FIG. 1.

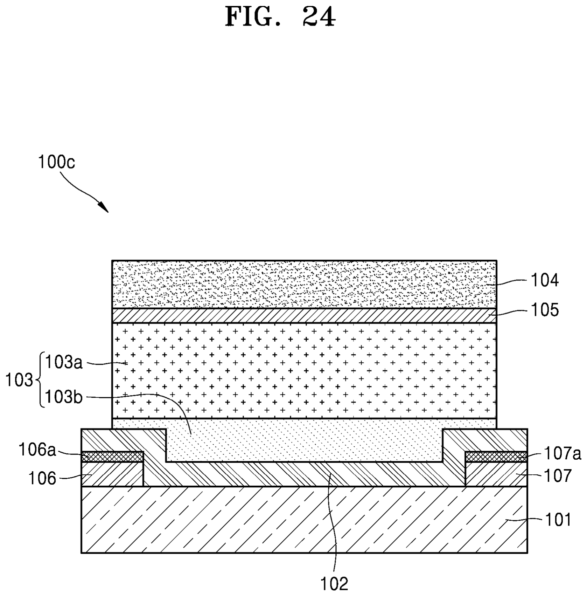

FIG. 24 is a schematic cross-sectional view showing a structure of a ferroelectric field effect transistor 100c according to at least one embodiment. In the above descriptions, the source electrode 106 and the drain electrode 107 are described as being disposed on the channel layer 102, but the source electrode 106 and the drain electrode 107 may be disposed under the channel layer 102. Referring to FIG. 24, the ferroelectric field effect transistor 100c may include the source electrode 106 and the drain electrode 107 which are disposed under the channel layer 102. In this case, the source electrode 106 and the drain electrode 107 may be spaced part from each other on the upper surface of the substrate 101. The opposite side edges of the channel layer 102 may extend over the side walls and upper surfaces of the source electrode 106 and the drain electrode 107. Furthermore, the ferroelectric field effect transistor 100c may further include the first contact layer 106a between the source electrode 106 and the channel layer 102 and the second contact layer 107a between the drain electrode 107 and the channel layer 102. The first contact layer 106a may be disposed on the upper surface of the source electrode 106 and the second contact layer 107a may be disposed on the upper surface of the drain electrode 107.

In the ferroelectric field effect transistor 100c illustrated in FIG. 24, the lower surface of the ferroelectric layer 103 may not be in contact with the source electrode 106 and the drain electrode 107. For example, the upper surface of the ferroelectric layer 103 may be only in contact with the conductive oxide layer 105, and the lower surface of the ferroelectric layer 103 may be only in contact with the channel layer 102. In particular, the lower surface of the second ferroelectric layer 103b may be only in contact with the channel layer 102 and may not be in contact with the source electrode 106 and the drain electrode 107. Also, the arrangement structure of the source electrode 106 and the drain electrode 107 illustrated in FIG. 24 may be applied to the ferroelectric field effect transistor 100 illustrated in FIG. 1.

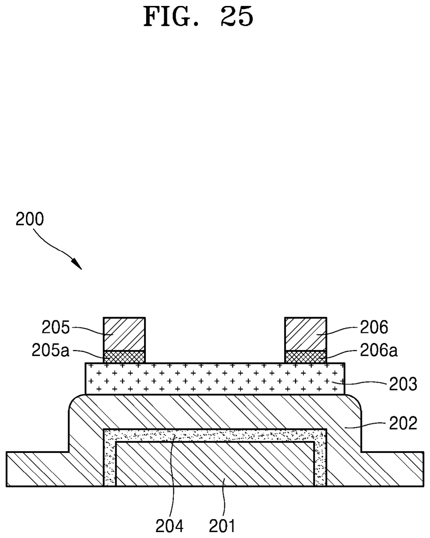

FIG. 25 is a schematic cross-sectional view showing a structure of a ferroelectric field effect transistor 200 according to at least one embodiment. Although the top gate structure in which the gate electrode 104 is placed on the top is described above, the ferroelectric field effect transistors according to embodiments need not be limited to the top gate structure and may have a bottom gate structure in which the gate electrode is placed on the bottom.

Referring to FIG. 25, the ferroelectric field effect transistor 200 according to at least one embodiment may include a gate electrode 201, a ferroelectric layer 202 surrounding both side surfaces and an upper surface of the gate electrode 201, a channel layer 203 disposed on an upper surface of the ferroelectric layer 202, a conductive oxide layer 204 provided between the gate electrode 201 and the ferroelectric layer 202, and a source electrode 205 and a drain electrode 206 spaced apart from each other on the channel layer 203 to be electrically connected to the channel layer 203. The conductive oxide layer 204 may surround both side surfaces and the upper surface of the gate electrode 201, and the ferroelectric layer 202 may surround both side surfaces and an upper surface of the conductive oxide layer 204. Alternatively, the conductive oxide layer 204 may disposed only on the upper surface of the gate electrode 201, and in this case, the ferroelectric layer 202 may be disposed only on the upper surface of the conductive oxide layer 204. As the materials, compositions, and functions of the layers illustrated in FIG. 25 are the same as (and/or substantially similar to) those described with reference to FIG. 1, detailed descriptions thereof are omitted, and differences therebetween are mainly described below.

The ferroelectric field effect transistor 200 illustrated in FIG. 25 has a bottom gate structure. In other words, the gate electrode 201 may be positioned at the lower portion of the ferroelectric field effect transistor 200, and the channel layer 203 may be positioned above the gate electrode 201 facing the gate electrode 201. The ferroelectric layer 202 may be provided between the gate electrode 201 and the channel layer 203. The conductive oxide layer 204 may be provided between the gate electrode 201 and the ferroelectric layer 202.

The source electrode 205 and the drain electrode 206 may be provided at a side opposite to the gate electrode 201 with respect to the channel layer 203. For example, the source electrode 205 and the drain electrode 206 may be dispose on the channel layer 203, and the gate electrode 201 may be disposed under the channel layer 203. The source electrode 205 and the drain electrode 206 may be spaced apart from each other on the upper surface of the channel layer 203. In other words, the channel layer 203 may include a first surface and a second surface opposite to each other, the source electrode 205 and the drain electrode 206 may be spaced apart from each other on the first surface of the channel layer 203, and the gate electrode 201 may be arranged to face the second surface of the channel layer 203.

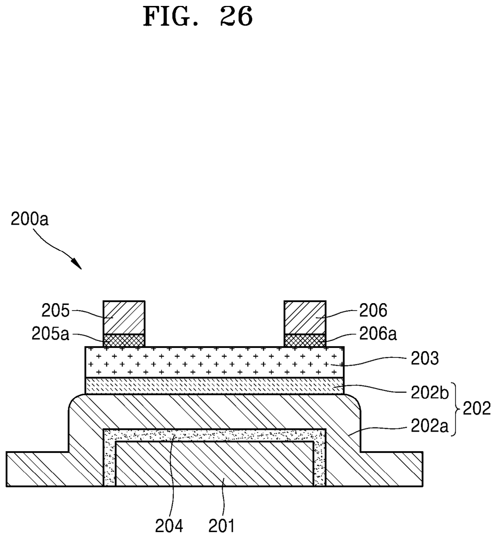

FIG. 26 is a schematic cross-sectional view showing a structure of a ferroelectric field effect transistor 200a according to at least one embodiment. Referring to FIG. 26, the ferroelectric layer 202 of the ferroelectric field effect transistor 200a according to at least one embodiment may include a first ferroelectric layer 202a and a second ferroelectric layer 202b. The first ferroelectric layer 202a may surround both side surfaces and an upper surface of the conductive oxide layer 204. The second ferroelectric layer 202b may be provided between the first ferroelectric layer 202a and the channel layer 203. The first ferroelectric layer 202a may be the same as (or substantially similar to) the first ferroelectric layer 103a described with reference to FIG. 4. The second ferroelectric layer 202b may be the same as (or substantially similar to) the second ferroelectric layer 103b described with reference to FIG. 4.

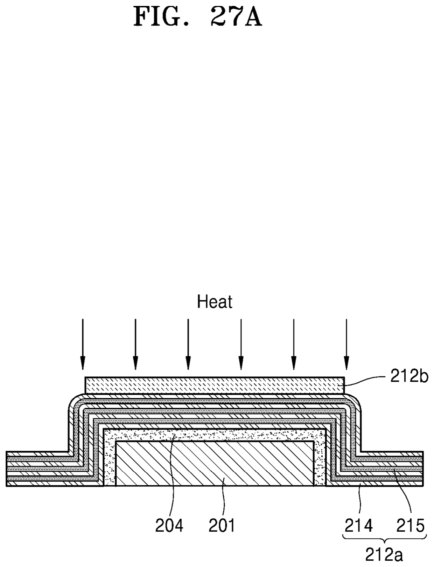

A process of manufacturing the ferroelectric field effect transistor 200a illustrated in FIG. 26 may be different from a process of manufacturing the ferroelectric field effect transistor 100a illustrated in FIG. 4 in terms of order. FIGS. 27A to 27C are schematic cross-sectional views showing a method of manufacturing the ferroelectric field effect transistor 200a illustrated in FIG. 26, according to at least one embodiment.

Referring to FIG. 27A, the gate electrode 201 may be first formed, the conductive oxide layer 204 may be formed on the gate electrode 201, and then a material layer (e.g., a ferroelectric precursor layer) of the ferroelectric layer 202 may be formed on the conductive oxide layer 204. When the first ferroelectric layer 202a includes a first metal oxide and a second metal oxide and the second ferroelectric layer 202b includes the oxide of the first metal, by alternately depositing a first metal oxide layer 214 including the oxide of the first metal and a second metal oxide layer 215 including the oxide of the second metal on the conductive oxide layer 204, multiple times, by the ALD method, the material layer of the first ferroelectric layer 202a, for example, a first ferroelectric precursor layer 212a, may be formed. Then, a material layer of the second ferroelectric layer 202b, for example, a second ferroelectric precursor layer 212b, may be formed by depositing the oxide of the first metal on the first ferroelectric precursor layer 212a, multiple times, by the ALD method.

For example, when the first ferroelectric layer 202a includes HZO and the second ferroelectric layer 202b includes HfO₂, the first ferroelectric precursor layer 212a may be formed by alternately depositing HfO₂ and ZrO₂ on the conductive oxide layer 204, multiple times, by the ALD method. Then, the second ferroelectric precursor layer 212b may be formed by depositing HfO₂ on the first ferroelectric precursor layer 212a, multiple times, by the ALD method.

In some example embodiments, any one of the first metal oxide layer 214 and the second metal oxide layer 215 may be first deposited, and any one of the first metal oxide layer 214 and second metal oxide layer 215 may be finally deposited. The total number of the first metal oxide layer 214 and the second metal oxide layer 215 may be even or odd.

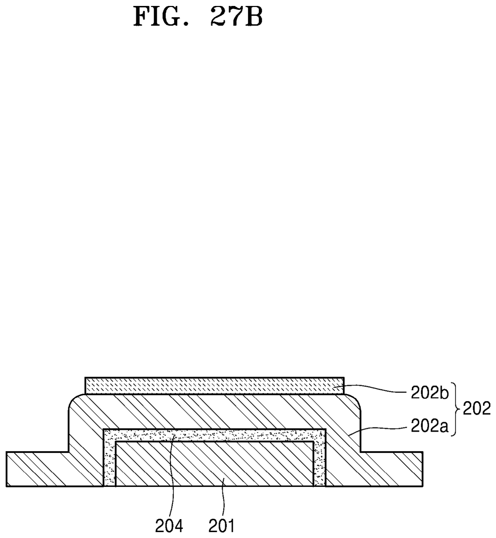

Then, by crystallizing the first ferroelectric precursor layer 212a and the second ferroelectric precursor layer 212b through annealing, as illustrated in FIG. 27B, the ferroelectric layer 202 including the first ferroelectric layer 202a and the second ferroelectric layer 202b may be formed.

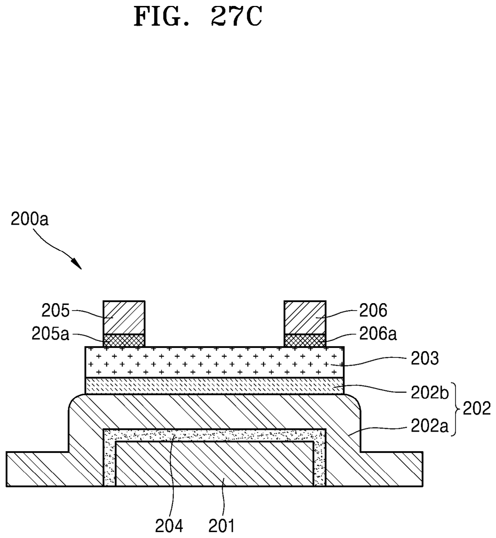

As illustrated in FIG. 27C, the channel layer 203 may be formed on the ferroelectric layer 202, and the source electrode 205 and the drain electrode 206 may be formed on the channel layer 203.

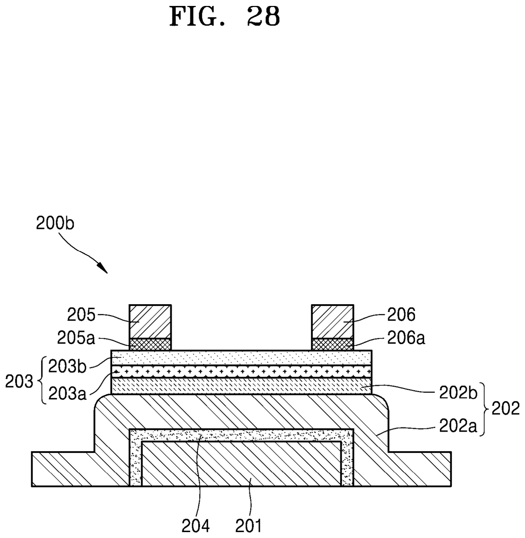

FIG. 28 is a schematic cross-sectional view showing a structure of a ferroelectric field effect transistor 200b according to at least one embodiment. Referring to FIG. 28, the channel layer 203 of the ferroelectric field effect transistor 200b according to at least one embodiment may have a multilayer structure. For example, the channel layer 203 may include a first channel layer 203a and a second channel layer 203b disposed on the first channel layer 203a. The first channel layer 203a may be disposed on the second ferroelectric layer 202b. The source electrode 205 and the drain electrode 206 may be spaced apart from each other on the second channel layer 203b. The first channel layer 203a and the second channel layer 203b may include different oxide semiconductor materials.

Although the ferroelectric field effect transistor having a planar channel in the horizontal direction is described above, it is possible to implement a ferroelectric field effect transistor having a vertical channel in the vertical direction.

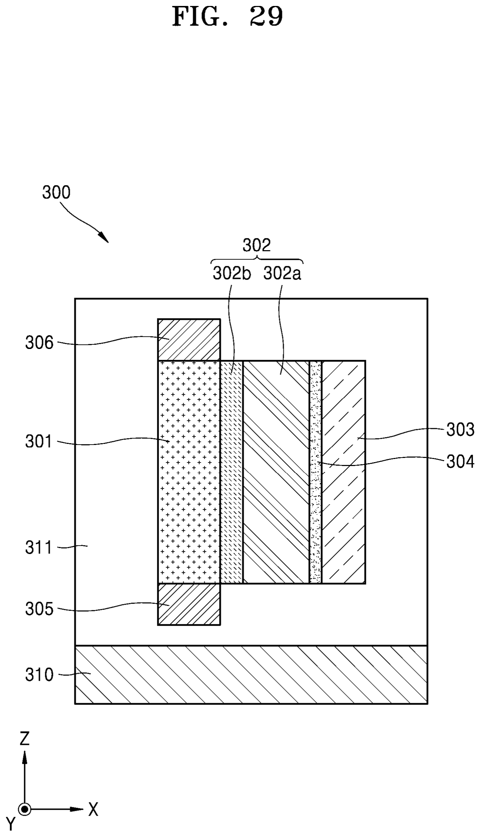

FIG. 29 is a schematic cross-sectional view showing a structure of a ferroelectric field effect transistor 300 according to at least one embodiment. Referring to FIG. 29, the ferroelectric field effect transistor 300 according to at least one embodiment may include a source electrode 305, a channel layer 301 disposed on the source electrode 305 and extending in a first direction (e.g.., the vertical direction or the Z-axis direction), a drain electrode 306 disposed on the channel layer 301, a gate electrode 303 provided to face one side surface of the channel layer 301 in a second direction (e.g., the horizontal direction or the X-axis direction) perpendicular to the first direction, a ferroelectric layer 302 provided between the one side surface of the channel layer 301 and the gate electrode 303 in the second direction, and a conductive oxide layer 304 provided between one side surface of the ferroelectric layer 302 and the gate electrode 303 in the second direction. Although omitted in FIG. 29, a first contact layer may be further provided between the source electrode 305 and the channel layer 301 in the first direction, and a second contact layer may be further provided between the drain electrode 306 and the channel layer 301 in the first direction.

The ferroelectric layer 302 may include a first ferroelectric layer 302a provided between the one side surface of the channel layer 301 and the conductive oxide layer 304 in the second direction and a second ferroelectric layer 302b provided between the one side surface of the channel layer 301 and the first ferroelectric layer 302a in the second direction. The conductive oxide layer 304 may be provided between the first ferroelectric layer 302a and the gate electrode 303 in the second direction. In another example, the ferroelectric layer 302 may have a single layer structure like the ferroelectric layer 103 of FIG. 1. As the materials, compositions, and functions of the layers described with reference to FIG. 29 are the same as (or substantially similar to) those described with reference to FIG. 4, detailed descriptions thereof are omitted, and differences therebetween are mainly described below.

As illustrated in FIG. 29, the channel layer 301, the ferroelectric layer 302, the conductive oxide layer 304, and the gate electrode 303 may be sequentially provided in the horizontal direction (e.g., the second direction) and may extend in the vertical direction (e.g., the first direction). The source electrode 305 and the drain electrode 306 may be electrically connected to upper/lower portions or both end portions of the channel layer 301 in the vertical direction (e.g., the first direction). The width in the second direction of the source electrode 305 and the width in the second direction of the drain electrode 306 may be the same as (or substantially similar to) the width in the second direction of the channel layer 301, or may be slightly greater or less than the width in the second direction of the channel layer 301. Even when the width in the second direction of the source electrode 305 and the width in the second direction of the drain electrode 306 are greater than the width in the second direction of the channel layer 301, while it may be possible for the source electrode 305 and the drain electrode 306 to be in contact with the ferroelectric layer 302, the source electrode 305 and the drain electrode 306 may not be in contact with the conductive oxide layer 304 and the gate electrode 303. Although the lengths in the first direction of the channel layer 301, the ferroelectric layer 302, the conductive oxide layer 304, and the gate electrode 303 may be the same (or substantially similar), the disclosure is not limited thereto.

The ferroelectric field effect transistor 300 may further include a substrate 310, and the source electrode 305 may be disposed on the upper surface of the substrate 310. The ferroelectric field effect transistor 300 may also further include an interlayer insulating layer 311 disposed on the substrate 310 to surround the channel layer 301, the ferroelectric layer 302, the conductive oxide layer 304, the gate electrode 303, the source electrode 305, and the drain electrode 306. In FIG. 29, the source electrode 305 is apart from the substrate 310 in the vertical direction (e.g.., the first direction), and the interlayer insulating layer 311 is provided between the source electrode 305 and the substrate 310. However, when the substrate 310 includes an insulating substrate, the source electrode 305 may be in direct contact with the upper surface of the substrate 310.

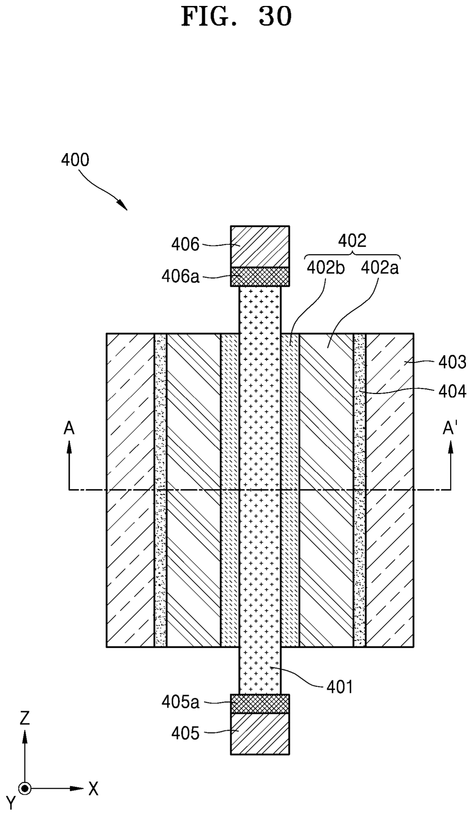

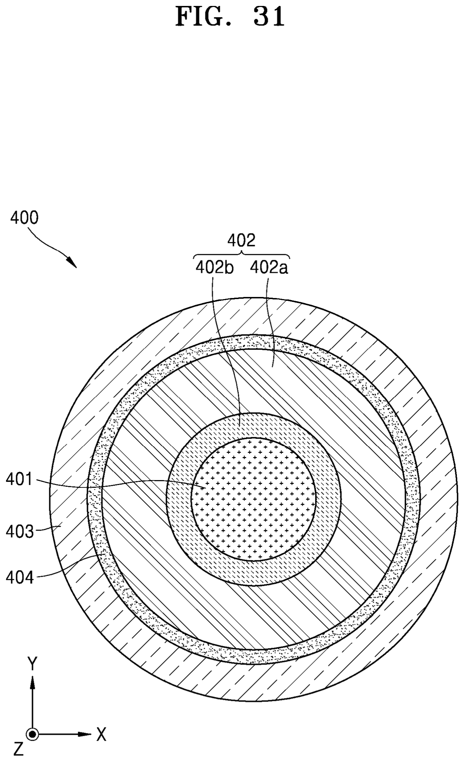

Although the ferroelectric field effect transistor having a vertical channel structure illustrated in FIG. 29 includes a plurality of layers having a planar shape which extend in the vertical direction and are arranged in the horizontal direction, the plurality of layers may be arranged in a concentric form. FIGS. 30 and 31 are schematic vertical and horizontal cross-sectional views, respectively, showing a structure of a ferroelectric field effect transistor 400 according to at least one embodiment. FIG. 31 schematically illustrates a structure of the ferroelectric field effect transistor 400 taken along line A-A' of FIG. 30. Referring to FIGS. 30 and 31, the ferroelectric field effect transistor 400 according to at least one embodiment may include a channel layer 401 having a cylindrical shape extending in the vertical direction or the first direction (the Z-axis direction), a ferroelectric layer 402 surrounding a circumference of the channel layer 401, a conductive oxide layer 404 surrounding a circumference of the ferroelectric layer 402, and a gate electrode 403 surrounding a circumference of the conductive oxide layer 404. The channel layer 401, the ferroelectric layer 402, the conductive oxide layer 404, and the gate electrode 403 may extend in the vertical direction or the first direction (the Z-axis direction) and may be arranged in a concentric form.

The ferroelectric layer 402 may include a first ferroelectric layer 402a provided between the channel layer 401 and the conductive oxide layer 404 and a second ferroelectric layer 402b provided between the channel layer 401 and the first ferroelectric layer 402a. The second ferroelectric layer 402b may surround a circumference of the channel layer 401, and the first ferroelectric layer 402a may surround a circumference of the second ferroelectric layer 402b. The conductive oxide layer 404 may be provided between the first ferroelectric layer 402a and the gate electrode 403. The conductive oxide layer 404 may surround a circumference of the first ferroelectric layer 402a. In another example, the ferroelectric layer 402 may have a single layer structure like the ferroelectric layer 103 of FIG. 1. As the materials, compositions, and functions of the layers illustrated in FIGS. 30 and 31 are the same as (or substantially similar to) those described with reference to FIGS. 1 and 4, detailed descriptions thereof are omitted, and differences therebetween are mainly described below.

The ferroelectric field effect transistor 400 may also include a source electrode 405 disposed on a lower surface of the channel layer 401 and a drain electrode 406 disposed on an upper surface of the channel layer 401. In other words, the source electrode 405 and the drain electrode 406 may be provided on both end portions of the channel layer 401 in the first direction. Furthermore, the ferroelectric field effect transistor 400 may further include a first contact layer 405a provided between the channel layer 401 and the source electrode 405 and a second contact layer 406a provided between the channel layer 401 and the drain electrode 406.

The channel layer 401 may protrude further in the first direction with respect to other layers, that is, the ferroelectric layer 402, the conductive oxide layer 404, and the gate electrode 403. In other words, the length in the first direction of the channel layer 401 may be greater than the lengths in the first direction of the ferroelectric layer 402, the conductive oxide layer 404, and the gate electrode 403. Although not illustrated in FIG. 29, in the embodiment of FIG. 29, the length of the channel layer 301 may be greater than the lengths of the other layers. In this case, the widths in the second direction of the source electrode 305 and the drain electrode 306 may not be limited. In at least one embodiment, in the cases of FIGS. 30 and 31, the length in the first direction of the channel layer 401 may be the same as (or substantially similar to) the lengths in the first direction of the ferroelectric layer 402, the conductive oxide layer 404, and the gate electrode 403. In this case, the widths in the second direction of the source electrode 405 and the drain electrode 406 may be limited to protecting against (e.g., preventing and/or reducing the potential for) the source electrode 405 and the drain electrode 406 from being in contact with the conductive oxide layer 404.

The configuration described above, which includes an oxide semiconductor channel layer, a ferroelectric layer, and a conductive oxide layer may be applied to a memory device having a vertical NAND (VNAND) structure that is a three-dimensional (or vertical) NAND (negative-AND).

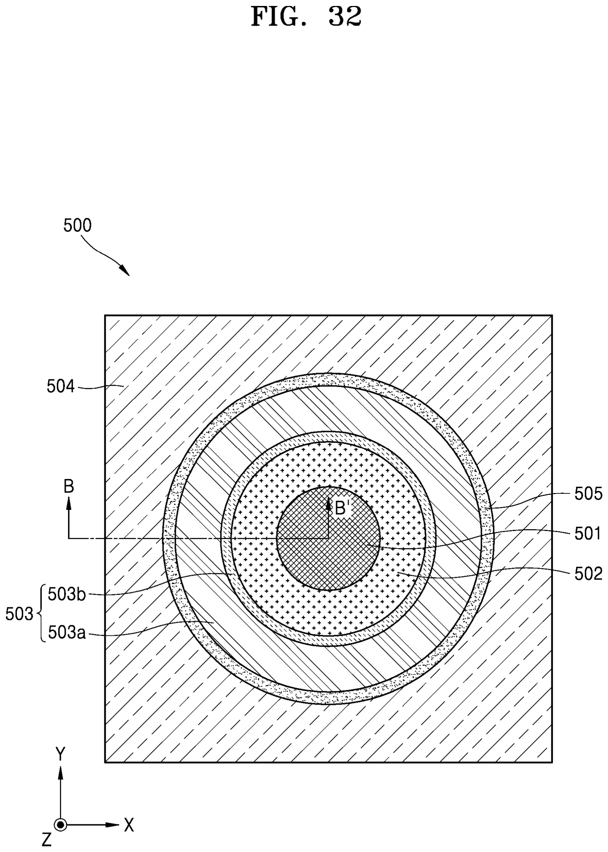

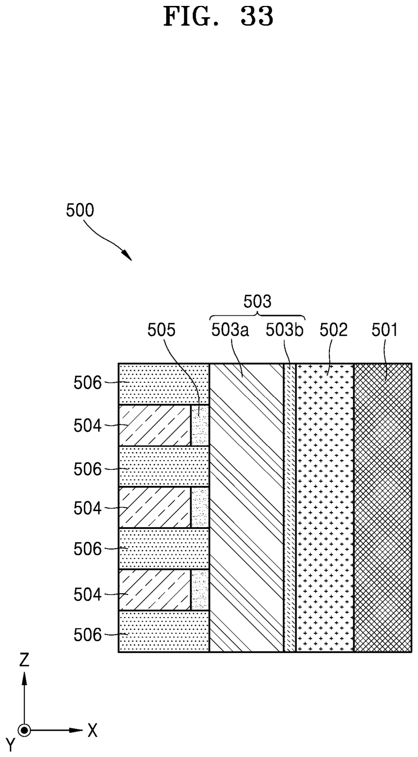

FIGS. 32 and 33 are schematic horizontal and vertical cross-sectional views, respectively, showing a structure of a memory cell string 500 of a memory device according to at least one embodiment. Referring to FIG. 32, the memory cell string 500 of a memory device according to at least one embodiment may include a center filler 501, a channel layer 502, a ferroelectric layer 503, a conductive oxide layer 505, and a gate electrode 504, which are arranged on an X-Y plane in a concentric form. The channel layer 502 may surround a circumference of the center filler 501 having a cylindrical shape, the ferroelectric layer 503 may surround a circumference of the channel layer 502, the conductive oxide layer 505 may surround a circumference of the ferroelectric layer 503, and the gate electrode 504 may surround a circumference of the conductive oxide layer 505. The center filler 501 may fill a space defined by the inner wall of the channel layer 502 to support the channel layer 502 and the memory cell string 500. However, the center filler 501 is not an essential element and may be omitted. In this case, an empty space may exist instead of the center filler 501.

FIG. 33 schematically illustrates the structure of the memory cell string 500 taken along line B-B' of FIG. 32 from the center of the center filler 501 to the gate electrode 504 in the first direction (e.g.., the Z-axis direction). Referring to FIG. 33, the memory cell string 500 may include a plurality of gate electrodes 504 alternately provided in the first direction, a plurality of spacers 506, the channel layer 502 facing and spaced apart from the plurality of gate electrodes 504 and the plurality of spacers 506 in the second direction (e.g.., the X-axis direction) and continuously extending in the first direction, the ferroelectric layer 503 continuously extending in the first direction and provided between the channel layer 502 and the plurality of gate electrodes 504 and between the channel layer 502 and the plurality of spacers 506, and a plurality of conductive oxide layers 505 provided between the ferroelectric layer 503 and the plurality of gate electrodes 504. The plurality of spacers 506 may each include silicon oxide (SiO₂) with insulating properties, but the disclosure is not limited thereto. The channel layer 502 may include the same (or a substantially similar) oxide semiconductor material as that of the channel layer 102 described with reference to FIG. 1. Furthermore, the memory cell string 500 may further include the center filler 501 continuously extending in the first direction inside the channel layer 502.

The plurality of conductive oxide layers 505, like the plurality of gate electrodes 504, may be alternately arranged with the plurality of spacers 506. In other words, the plurality of conductive oxide layers 505 may each be provided between the two spacers 506 adjacent to each other in the first direction. Each of the plurality of conductive oxide layers 505 may be provided between a corresponding gate electrode of the plurality of gate electrodes 504 and the ferroelectric layer 503. Each of the plurality of conductive oxide layers 505 may include the same (or a substantially similar) material as that of the conductive oxide layer 105 described with reference to FIG. 1.

The ferroelectric layer 503 may include the same (or a substantially similar) ferroelectric material as that of the ferroelectric layer 103 described with reference to FIG. 1. Furthermore, the ferroelectric layer 503 may include a first ferroelectric layer 503a continuously extending in the first direction between the channel layer 502 and the plurality of conductive oxide layers 505 and between the channel layer 502 and the plurality of spacers 506, and a second ferroelectric layer 503b continuously extending in the first direction between the channel layer 502 and the first ferroelectric layer 503a. The first ferroelectric layer 503a may be the same as (or substantially similar to) the first ferroelectric layer 103a described with reference to FIG. 4. The second ferroelectric layer 503b may be the same as (or substantially similar to) the second ferroelectric layer 103b described with reference to FIG. 4.

Although it is not illustrated, a source electrode and a drain electrode may be electrically connected to both end portions of the channel layer 502 in the first direction. For example, the source electrode may be provided on the lower side of the channel layer 502, and the drain electrode may be provided on the upper side of the channel layer 502. The source electrode and the drain electrode may extend in the second direction to be in contact with the center filler 501, the channel layer 502, and the ferroelectric layer 503. Altematively, the source electrode and the drain electrode may be in contact with the center filler 501 and the channel layer 502 only.

In the memory cell string 500 illustrated in FIGS. 32 and 33, one gate electrode 504, and the conductive oxide layer 505, a portion of the ferroelectric layer 503, and a portion of the channel layer 502, which are adjacent to the gate electrode 504 in the second direction, may form one memory cell. In this point, the memory cell string 500 may include a plurality of memory cells stacked in the first direction. Furthermore, the memory device having a VNAND structure may include a plurality of memory cell strings 500 that are two-dimensionally arranged.

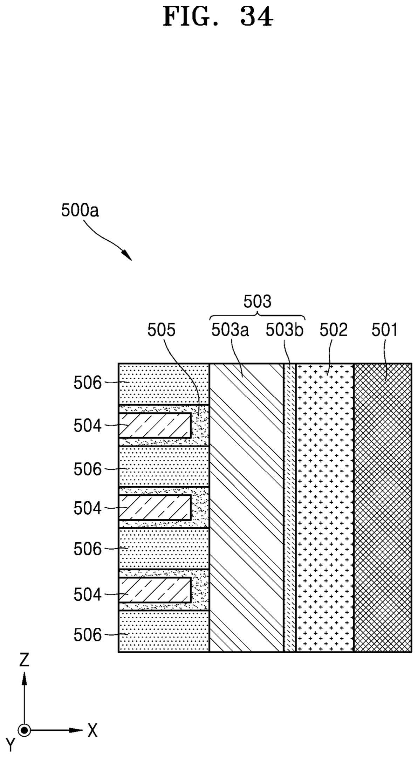

FIG. 34 is a schematic vertical cross-sectional view showing a structure of a memory cell string 500a of a memory device according to at least one embodiment. Referring to FIG. 34, each of the plurality of conductive oxide layers 505 of the memory cell string 500a may be provided to cover the upper surface and lower surface of a corresponding gate electrode of the plurality of gate electrodes 504. In other words, each of the plurality of conductive oxide layers 505 may extend from between a corresponding gate electrode of the plurality of gate electrodes 504 and the ferroelectric layer 503 to the upper surface and lower surface of the corresponding gate electrode. Accordingly, the conductive oxide layer 505 may be provided between the plurality of spacers 506 and the gate electrode 504.

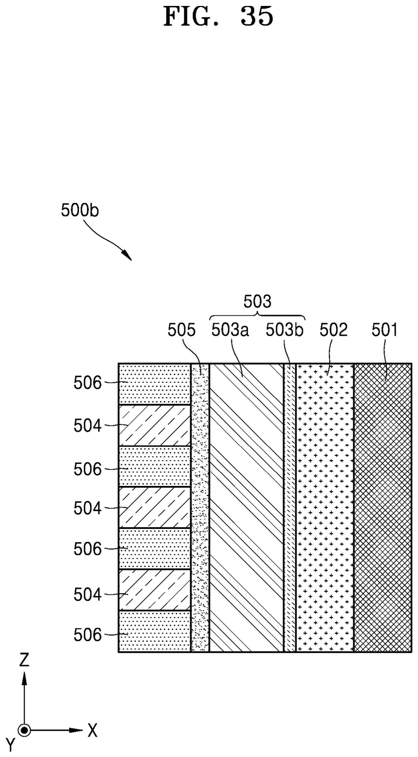

FIG. 35 is a schematic vertical cross-sectional view showing a structure of a memory cell string 500b of a memory device according to at least one embodiment. Referring to FIG. 35, the memory cell string 500b may include one conductive oxide layer 505 that continuously extends in the first direction between the plurality of gate electrodes 504 and the ferroelectric layer 503 and between the plurality of spacers 506 and the ferroelectric layer 503.

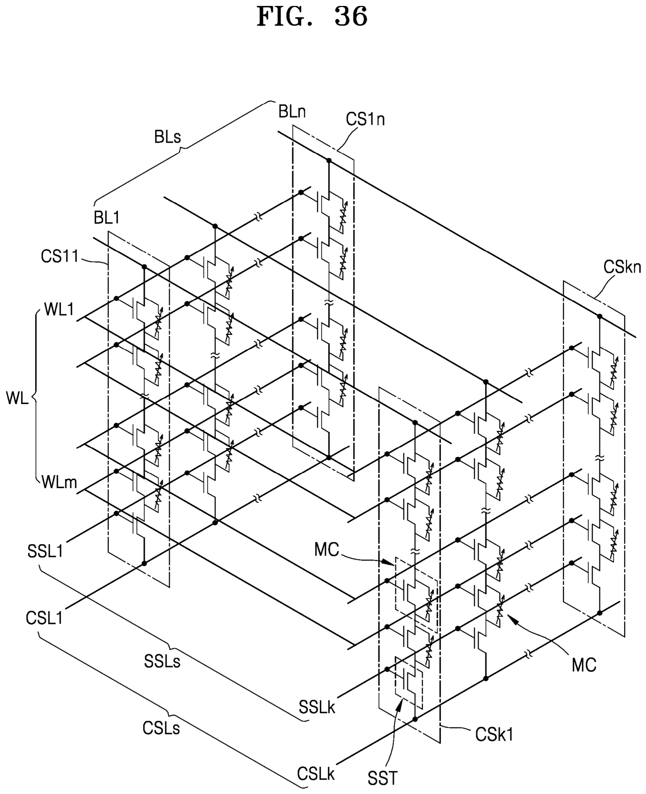

FIG. 36 is an equivalent circuit diagram showing a memory device according to at least one embodiment. Referring to FIG. 36, the memory device may include a plurality of memory cell strings CS11 to CSkn. The plurality of memory cell strings CS11 to CSkn may be two-dimensionally arranged in a row direction and a column direction to form rows and columns. Each of the memory cell string CS11 to CSkn may include a plurality of memory cells MCs and a plurality of string selection transistors SSTs. The memory cells MCs and the string selection transistors SSTs of each of the memory cell string CS11 to CSkn may be stacked in a height direction. The memory cells MCs in each of the memory cell string CS11 to CSkn may each correspond to a circuit with a transistor and a resistor connected in parallel. For example, the transistors may include any one of the ferroelectric field effect transistors 100, 100a, 100b, 100c, 200, 200a, 200b, 300 and/or 400 described above; and/or each of the memory cell string CS11 to CSkn may be the memory cell string 500 illustrated in FIGS. 32 and 33 and/or the memory cell string 500a illustrated in FIG. 34.

The rows of the plurality of memory cell strings CS11 to CSkn may be connected to different string selection lines SSL1 to SSLk, respectively. For example, the string selection transistors SSTs of the memory cell strings CS11 to CS1n are connected in common to the string selection line SSL1. The string selection transistors SSTs of the memory cell strings CSk1 to CSkn are connected in common to the string selection line SSLk.

Furthermore, the columns of the plurality of memory cell strings CS11 to CSkn are connected to different bit lines BL1 to BLn, respectively. For example, the memory cells MCs and the string selection transistors SSTs of the memory cell strings CS11 to CSk1 may be connected in common to the bit line BL1, and the memory cells MCs and the string selection transistors SSTs of the memory cell strings CS1n to CSkn may be connected in common to the bit line BLn.

Furthermore, the rows of the plurality of memory cell strings CS11 to CSkn may be connected to different common source lines CSL1 to CSLk, respectively. For example, the string selection transistors SSTs of the plurality of memory cell strings CS11 to CS1n may be connected in common to the common source line CSL1, and the string selection transistors SSTs of the plurality of memory cell strings CSk1 to CSkn may be connected in common to the common source line CSLk.

The memory cells MCs (or the string selection transistors SSTs) positioned at the same (or a substantially similar) height from a substrate may be connected in common to one word line WL, and the memory cells MCs positioned at different heights may be connected to different word lines WL1 to WLm, respectively.

In the above structure, write and read operations may be performed in units of rows of the memory cell strings CS11 to CSkn. For example, the memory cell strings CS11 to CSkn may be selected row by row by the common source lines CSLs, and the memory cell strings CS11 to CSkn may be selected row by row by the string selection lines SSLs. In the selected row of the memory cell strings CS11 to CSkn, the write and read operations may be performed in units of pages. For example, a page may be one row of the memory cells MCs connected to one word line WL. In the selected row of the memory cell strings CS11 to CSkn, the memory cells MCs may be selected by the word lines WLs in units of pages.

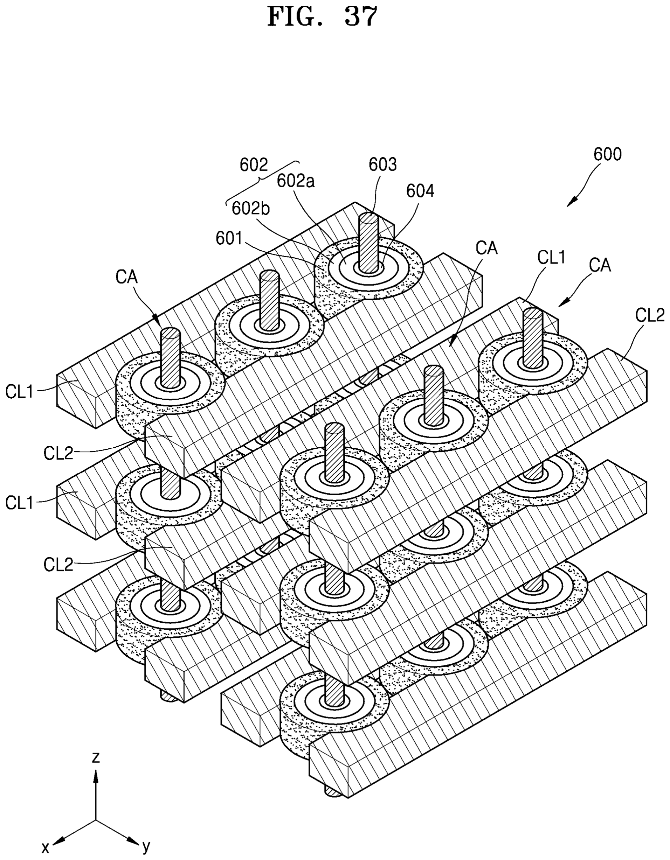

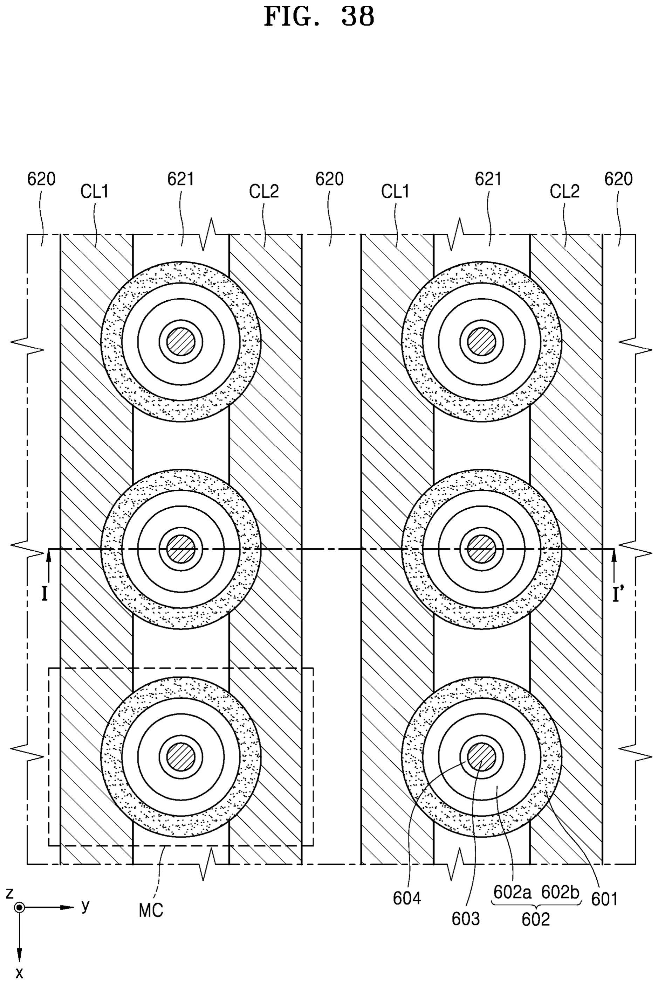

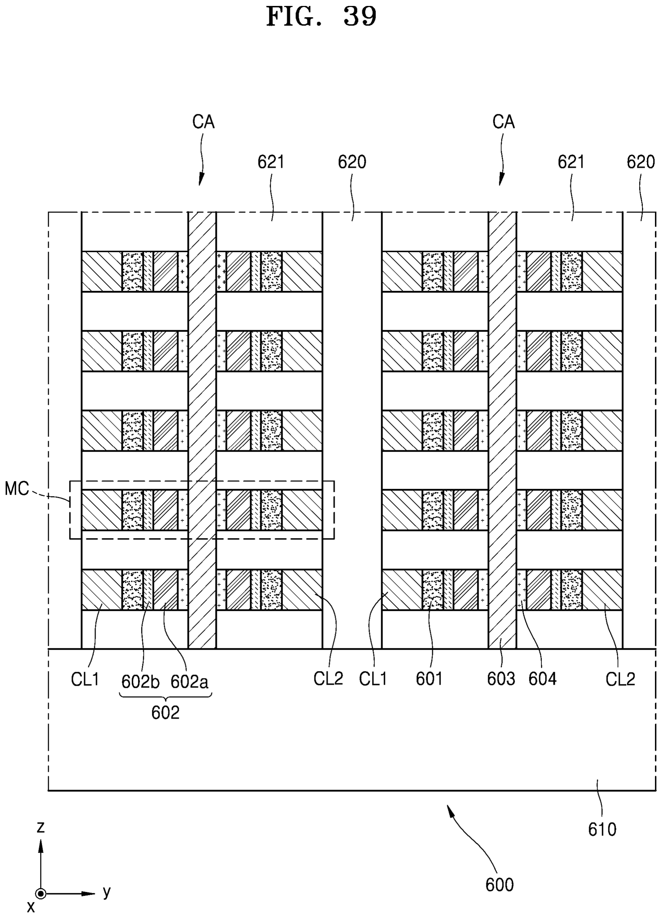

FIG. 37 is a schematic perspective view showing a configuration of a memory device 600 according to at least one embodiment. FIG. 38 is a plan view of the memory device 600 illustrated in FIG. 37. FIG. 39 is a schematic cross-sectional view showing a structure of the memory device 600 taken along line I-I' of FIG. 38, according to at least one embodiment.

Referring to FIGS. 37 to 39, the memory device 600 may include a plurality of cell arrays CAs that are two-dimensionally arranged on a substrate 610. FIG. 37 illustrates a case in which the plurality of cell arrays CAs are provided in a second direction (an X-axis direction) parallel to the substrate 610 (i.e., parallel to the upper surface of the substrate 610) and a third direction (a Y-axis direction) perpendicularly crossing a first direction (a Z-axis direction) and the second direction. Each of the plurality of cell arrays CAs may extend in the first direction perpendicular to the substrate 610. Each of the plurality of cell arrays CAs may include the plurality of memory cells MCs provided on the substrate 610 to be spaced apart from each other in the first direction. Each of the plurality of memory cells MCs may include a ferroelectric field-effect transistor.

A first conductive line CL1 and a second conductive line CL2 extending in the second direction may be provided on both sides of each of the plurality of memory cells MCs of the plurality of cell arrays CAs spaced apart from each other in the second direction parallel to the substrate 610. For example, the first conductive line CL1 and the second conductive line CL2 may be a source electrode and a drain electrode, respectively. The first conductive line CL1 and the second conductive line CL2 may each be shared by the plurality of memory cells MCs of the plurality of cell arrays CAs arranged in the second direction. A plurality of first conductive lines CL1 and/or a plurality of second conductive lines CL2 may be spaced apart from each other in the first direction and the third direction.

An isolation layer 620 may be provided between the cell arrays CAs spaced apart from each other in the third direction parallel to the substrate 610. An insulating layer 621 may be provided between the plurality of memory cells MCs spaced apart from each other in the first direction perpendicular to the substrate 610. Furthermore, the isolation layer 620 may surround each of the plurality of memory cells MCs and fill between the first conductive line CL1 and the second conductive line CL2.

The substrate 610 may include various materials. For example, the substrate 610 may include a single crystal silicon substrate, a compound semiconductor substrate, or a silicon on insulator (SOI) substrate, but the disclosure is not limited thereto. Furthermore, the substrate 610 may further include, for example, an impurity doped region, an electronic element such as a transistor, or a periphery circuit for selecting and controlling the plurality of memory cells MCs that stores data.

The plurality of memory cells MCs may each have a structure in which a gate electrode 603, a conductive oxide layer 604, a ferroelectric layer 602, and a channel layer 601 are sequentially stacked in a direction parallel to the substrate 610. The gate electrode 603 may extend in the first direction perpendicular to the substrate 610 and may be shared by the plurality of memory cells MCs constituting one cell array CA. The conductive oxide layer 604, the ferroelectric layer 602, and the channel layer 601 may each be formed in a cylinder shape surrounding the gate electrode 603. For example, the conductive oxide layer 604 may surround the gate electrode 603, the ferroelectric layer 602 may surround the conductive oxide layer 604, and the channel layer 601 may surround the ferroelectric layer 602. Both sides of the channel layer 601 may be electrically connected to a corresponding first conductive line of the plurality of first conductive lines CL1s and a corresponding second conductive line of the plurality of second conductive lines CL2s. The conductive oxide layer 604, the ferroelectric layer 602, and the channel layer 601 of each of the plurality of memory cells MCs may be spaced apart from the conductive oxide layer 604, the ferroelectric layer 602, and the channel layer 601 of another memory cell MC, respectively, in the first direction.

The gate electrode 603 may include the same (or a substantially similar) material as that of the gate electrode 104 described with reference to FIG. 1. The conductive oxide layer 604 may include the same (or a substantially similar) material as that of the conductive oxide layer 105 described with reference to FIG. 1. The ferroelectric layer 602 may include the same (or a substantially similar) material as that of the ferroelectric layer 103 described with reference to FIG. 1. The channel layer 601 may include the same (or a substantially similar) material as that of the channel layer 102 described with reference to FIG. 1.

In another example, the ferroelectric layer 602 may include the same (or a substantially similar) material as the ferroelectric layer 103 described with reference to FIG. 4. For example, the ferroelectric layer 602 may include a first ferroelectric layer 602a adjacent to the conductive oxide layer 604 and a second ferroelectric layer 602b provided between the channel layer 601 and the first ferroelectric layer 602a. The first ferroelectric layer 602a may include the same (or a substantially similar) material as that of the first ferroelectric layer 103a described with reference to FIG. 4. The second ferroelectric layer 602b may include the same (or substantially similar to) material as that of the second ferroelectric layer 103b described with reference to FIG. 4.

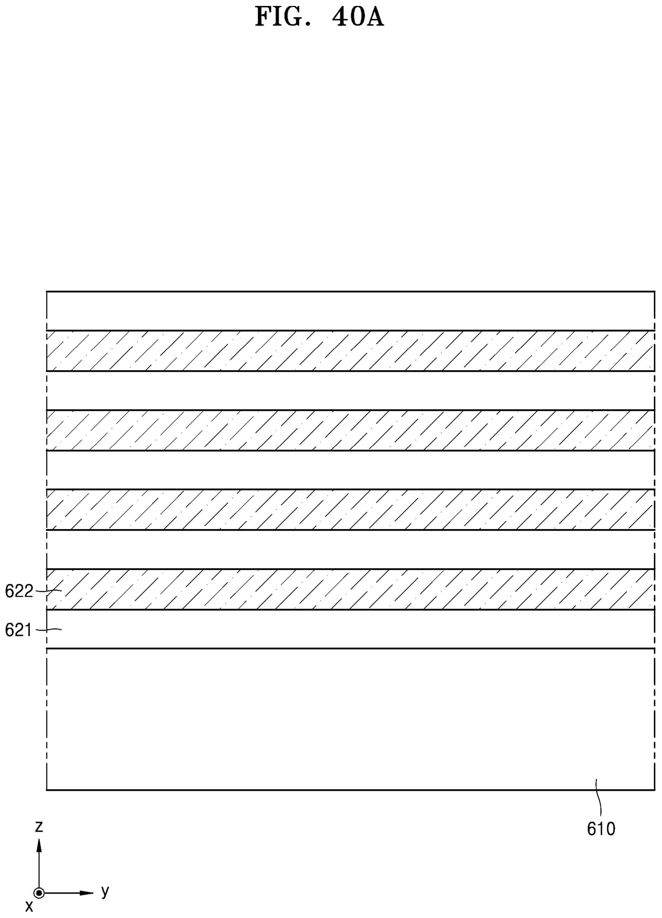

FIGS. 40A to 40H are schematic cross-sectional views showing a method of manufacturing the memory device 600 illustrated in FIGS. 37 to 39, according to at least one embodiment.

Referring to FIG. 40A, a plurality of insulating layers 621 and a plurality of sacrificial layers 622 may be alternately formed on and above the substrate 610. The plurality of insulating layers 621 and the plurality of sacrificial layers 622 may be alternately stacked in the first direction (the Z-axis direction) perpendicular to the upper surface of the substrate 610. The plurality of sacrificial layers 622 may each be provided between two insulating layers 621 adjacent to each other. The lowermost insulating layer of the plurality of insulating layers 621 may be provided between the lowermost sacrificial layer of the plurality of sacrificial layers 622 and the substrate 610. Also, the uppermost insulating layer of the plurality of insulating layers 621 may be provided on the uppermost sacrificial layer of the plurality of sacrificial layers 622. The plurality of insulating layers 621 and the plurality of sacrificial layers 622 may include different insulating materials. In particular, the plurality of sacrificial layers 622 may include a material having etching selectivity with respect to the plurality of insulating layers 621. For example, the plurality of insulating layers 621 may include silicon oxide, and the plurality of sacrificial layers 622 may include silicon nitride.

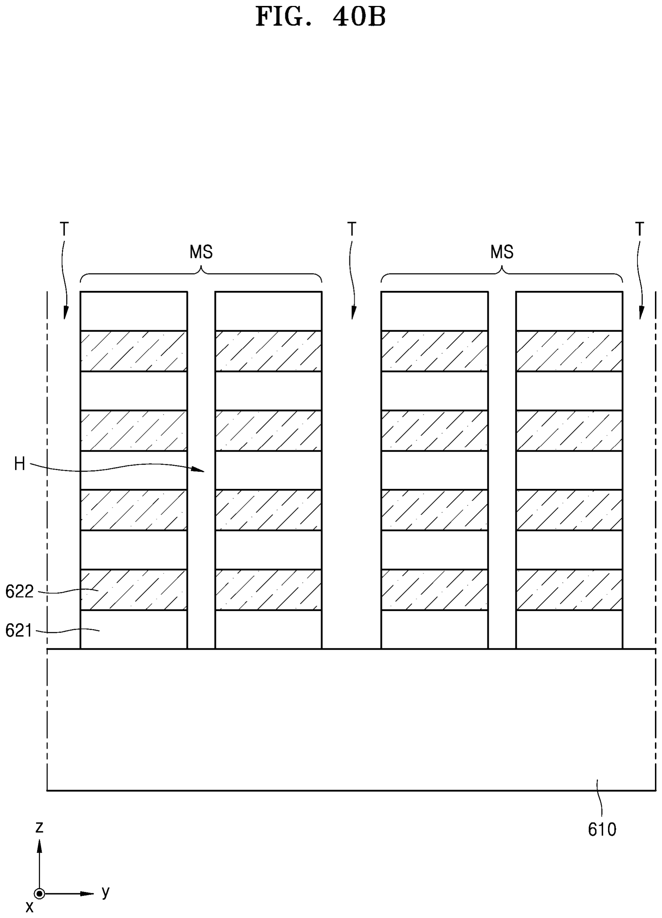

Referring to FIG. 40B, in order to expose the upper surface of the substrate 610, a plurality of trenches Ts may be formed to penetrate the plurality of insulating layers 621 and the plurality of sacrificial layers 622 in the first direction. For example, the plurality of trenches Ts may be formed by anisotropically etching the plurality of insulating layers 621 and the plurality of sacrificial layers 622. The plurality of trenches Ts may extend in the second direction (the X-axis direction) and may be spaced apart from each other in the third direction (the Y-axis direction). A mold structure MS may be formed between the plurality of trenches Ts. Each of a plurality of mold structures MSs may be provided between two trenches Ts adjacent to each other in the third direction, and two mold structures MSs adjacent to each other may be separated by the trench T therebetween.

Furthermore, in order to expose the upper surface of the substrate 610, a plurality of holes Hs may be formed, within the mold structure MS, to penetrate the plurality of insulating layers 621 and the plurality of sacrificial layers 622 in the first direction. For example, the plurality of holes Hs may be formed by anisotropically etching the plurality of insulating layers 621 and the plurality of sacrificial layers 622. The plurality of holes Hs may be spaced apart from each other in the second direction between two trenches Ts adjacent to each other.

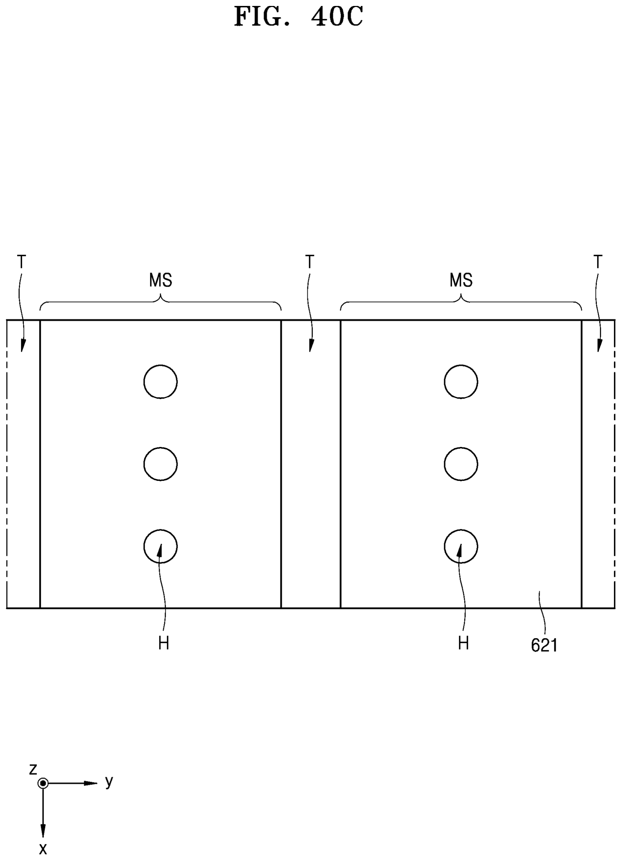

FIG. 40C is a plan view of the plurality of trenches Ts and the plurality of holes Hs illustrated in FIG. 40B. Referring to FIG. 40C, each of the plurality of trenches Ts may extend in the second direction to separate two mold structures MSs adjacent to each other. The plurality of holes Hs may be arranged in one mold structure MS to be spaced apart from each other in the second direction. Each of the plurality of holes Hs may have a circular shape, but the disclosure is not limited thereto. The side surfaces of the plurality of insulating layers 621 and the side surfaces of the plurality of sacrificial layers 622 may be exposed by the hole H.

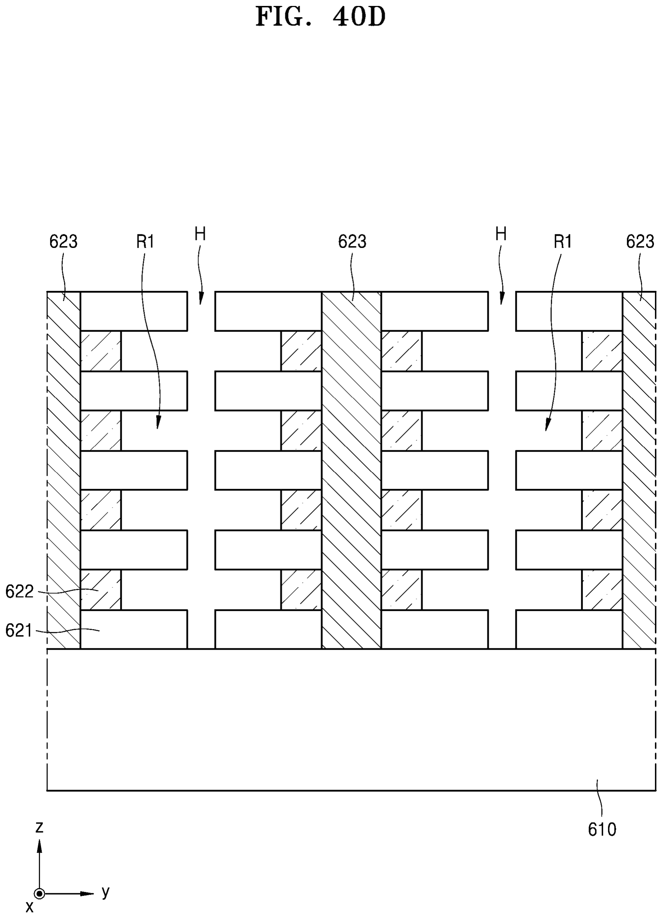

Referring to FIG. 40D, a sacrificial pattern 623 may be formed in each of the plurality of trenches Ts. The sacrificial pattern 623 may include a material having etching selectivity with respect to the sacrificial layer 622. For example, the sacrificial pattern 623 may include silicon oxide. For example, the sacrificial pattern 623 may be formed by filing the plurality of trenches Ts with silicon oxide. The sacrificial pattern 623 may conformally cover the inner surface of the trench T, that is, both side surfaces of the mold structure MS, and extend in the second direction.

Furthermore, a plurality of first recess areas R1s may be formed by further laterally etching the exposed side surfaces of the plurality of sacrificial layers 622 within each of the holes Hs. For example, the plurality of first recess areas R1s may be formed by providing an etchant having etching selectivity with respect to the plurality of sacrificial layers 622 into the hole H. The plurality of first recess areas R1s may each have a ring shape surrounding the hole H.

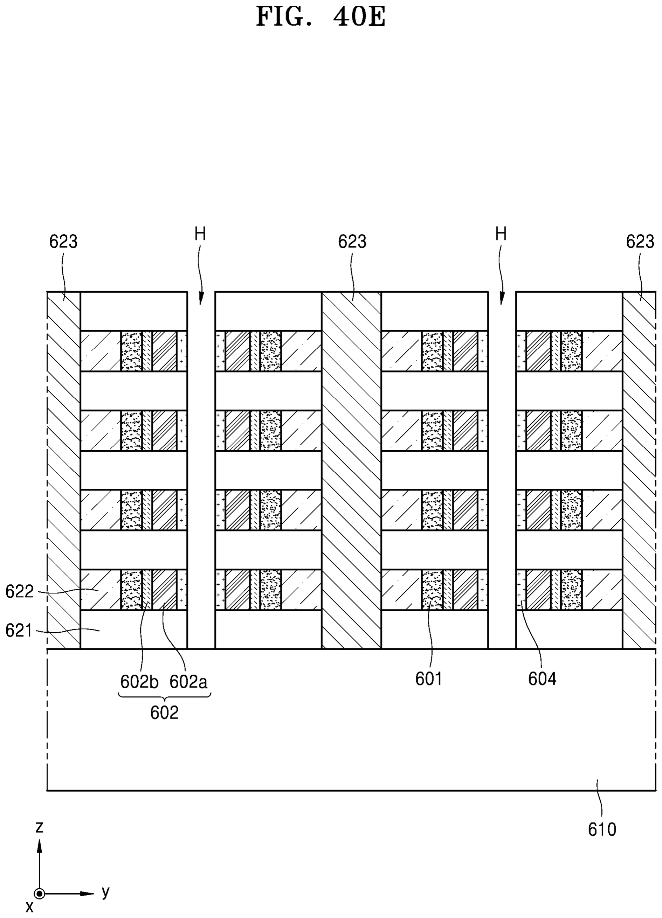

Referring to FIG. 40E, the plurality of channel layers 601, the plurality of ferroelectric layers 602, and the plurality of conductive oxide layers 604 may be sequentially formed within the plurality of first recess areas R1s. The plurality of channel layers 601 may be spaced apart from each other in the first direction, the plurality of ferroelectric layers 602 may be spaced apart from each other in the first direction, and the plurality of conductive oxide layers 604 may be spaced apart from each other in the first direction. The plurality of ferroelectric layers 602 may each include the first ferroelectric layer 602a and the second ferroelectric layer 602b. When forming the ferroelectric layer 602, the second ferroelectric layer 602b and the first ferroelectric layer 602a may be sequentially formed. Accordingly, materials of the channel layer 601, the second ferroelectric layer 602b, the first ferroelectric layer 602a, and the conductive oxide layer 604 may be sequentially formed in each of the plurality of first recess areas R1s.

For example, after forming the material of the channel layer 601 to fill a portion of the hole H and each of the plurality of first recess areas R1s along the side surface of the insulating layer 621 and the side surface of the sacrificial layer 622 within the hole **H,** the material of the channel layer 601 remaining in the hole H may be removed, and then the channel layer 601 may be formed by etching the material of the channel layer 601 in the plurality of first recess areas R1s until the material remains at a certain thickness. Next, after forming a second ferroelectric precursor layer to fill the portion of the hole H and each of the plurality of first recess areas R1s along the side surface of the insulating layer 621 and the side surface of the channel layer 601 within the hole **H,** the second ferroelectric precursor layer remaining in the hole H may be removed, and then the second ferroelectric precursor layer in the plurality of first recess areas R1s may be etched until the second ferroelectric precursor layer remains at a certain thickness. Then, after forming a first ferroelectric precursor layer to fill the portion of the hole H and each of the plurality of first recess areas R1s along the side surface of the insulating layer 621 and the side surface of second ferroelectric precursor layer within the hole **H,** the first ferroelectric precursor layer remaining in the hole H may be removed, and then the first ferroelectric precursor layer in the plurality of first recess areas R1s may be etched until the first ferroelectric precursor layer remains at a certain thickness. Then, after forming the conductive oxide layer 604 to fill the portion of the hole H and each of the plurality of first recess areas R1s along the side surface of the insulating layer 621 and the side surface of the first ferroelectric precursor layer within the hole **H,** the material of the conductive oxide layer 604 remaining in the hole H may be removed.

The first ferroelectric layer 602a and the second ferroelectric layer 602b may be formed by crystallizing the first ferroelectric precursor layer and the second ferroelectric precursor layer through annealing. Alternatively, before forming the conductive oxide layer 604 after forming the second ferroelectric precursor layer and the first ferroelectric precursor layer, the first ferroelectric layer 602a and the second ferroelectric layer 602b may be formed through annealing. Alternatively, annealing may be performed both before and after forming the conductive oxide layer 604, for example, annealing may be performed after forming the second ferroelectric precursor layer and the first ferroelectric precursor layer and after forming the conductive oxide layer 604.

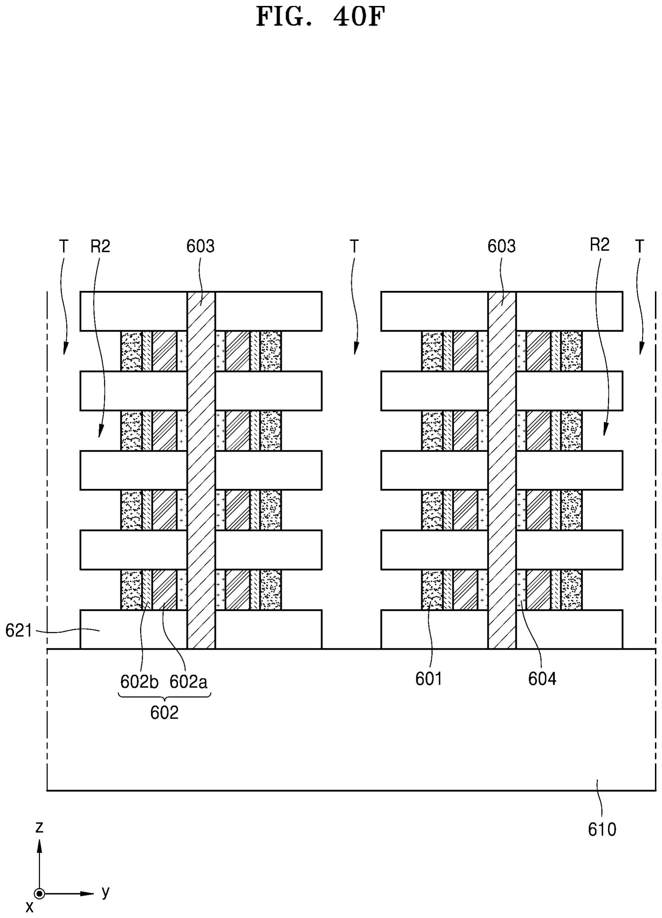

Referring to FIG. 40F, the gate electrode 603 may be formed by filling each hole H with a conductive material (such as metal, metal nitride, metal carbide, or polysilicon). Accordingly, the plurality of conductive oxide layers 604 spaced apart from each other in the first direction, the plurality of first ferroelectric layers 602a spaced apart from each other in the first direction, the plurality of second ferroelectric layers 602b spaced apart from each other in the first direction, and the plurality of channel layers 601 spaced apart from each other in the first direction may be arranged in a concentric form around one gate electrode 603.

Then, by etching the sacrificial pattern 623, the sacrificial pattern 623 may be removed from each of the plurality of trenches Ts. Accordingly, the side surfaces of the plurality of insulating layers 621 and the side surfaces of the plurality of sacrificial layers 622 may be exposed within the plurality of trenches Ts. Then, by selectively etching and removing the plurality of sacrificial layers 622 that are exposed, a plurality of second recess areas R2s may be formed. The plurality of second recess areas R2s may be spaced apart from each other in the first direction, and provided between two insulating layers 621 adjacent to each other in the first direction. Furthermore, the plurality of second recess areas R2s may each have a line shape extending in the second direction. The side surface of the channel layer 601 may be exposed by the plurality of second recess areas R2s.

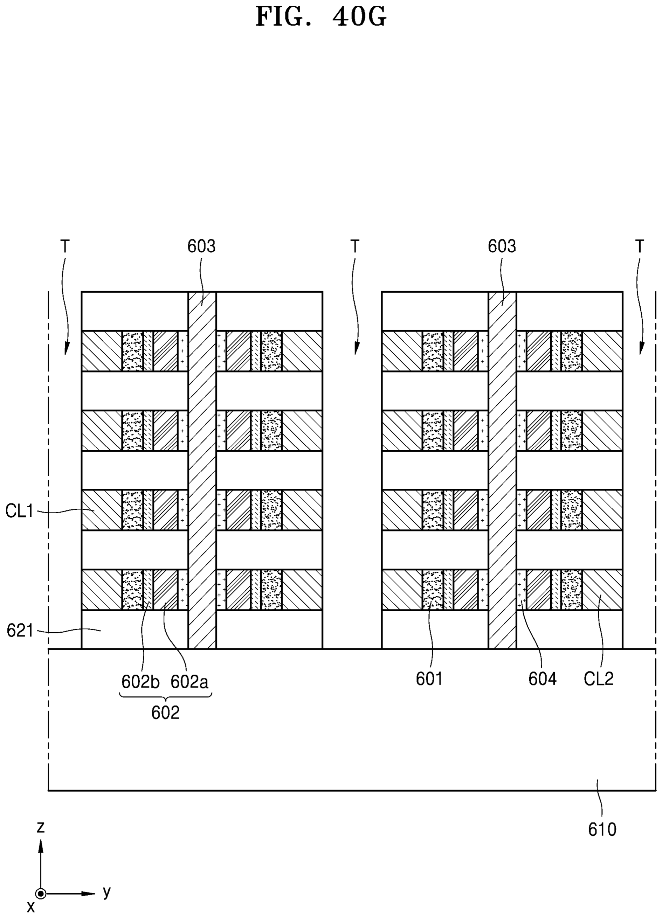

Referring to FIG. 40G, by filling the plurality of second recess areas R2s with a conductive material, the plurality of first conductive lines CL1s and the plurality of second conductive lines CL2s may be formed. For example, after forming a conductive material to fill the plurality of second recess areas R2s and a portion of the trench T, the conductive material in the trench T is removed so that the plurality of first conductive lines CL1s and the plurality of second conductive lines CL2s may be formed. The plurality of first conductive lines CL1s may be spaced apart from each other in the first direction, and the plurality of second conductive lines CL2s may be spaced apart from each other in the first direction. The plurality of first conductive lines CL1s and the plurality of second conductive lines CL2s may be respectively adjacent to both side surfaces of a corresponding channel layer of the plurality of channel layers 601. The plurality of first conductive lines CL1s and the plurality of second conductive lines CL2s may each have a line shape extending in the second direction.

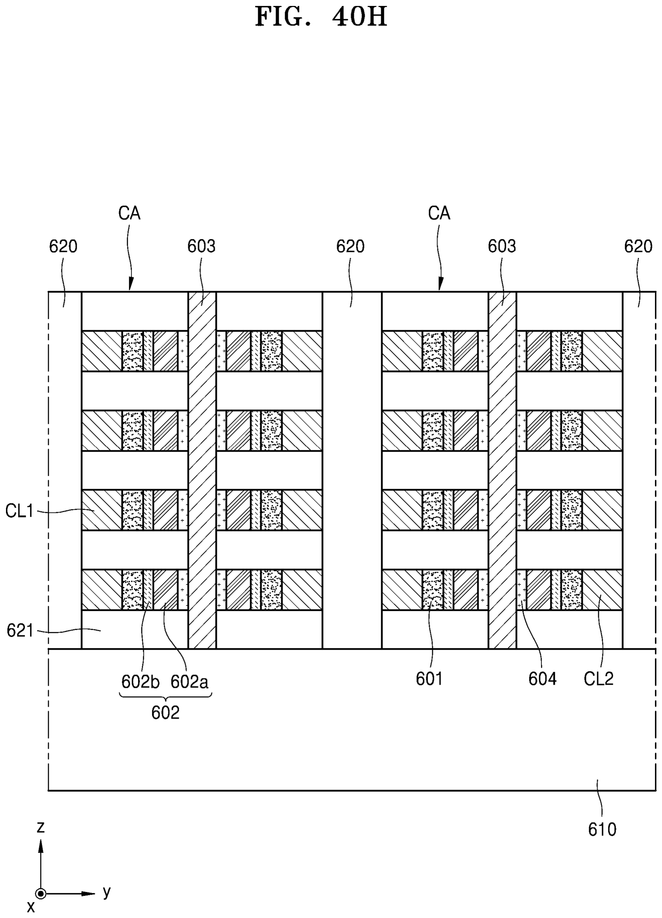

Referring to FIG. 40H, the plurality of isolation layers 620 may be formed by filling the trench T with an insulating material. The plurality of isolation layers 620 may extend in the second direction and may be spaced apart from each other in the third direction. One row of cell arrays CAs extending in the second direction may be provided between two isolation layers 620 adjacent to each other. The plurality of cell arrays CAs spaced apart from each other in the third direction may be electrically separated from each other by the isolation layer 620.

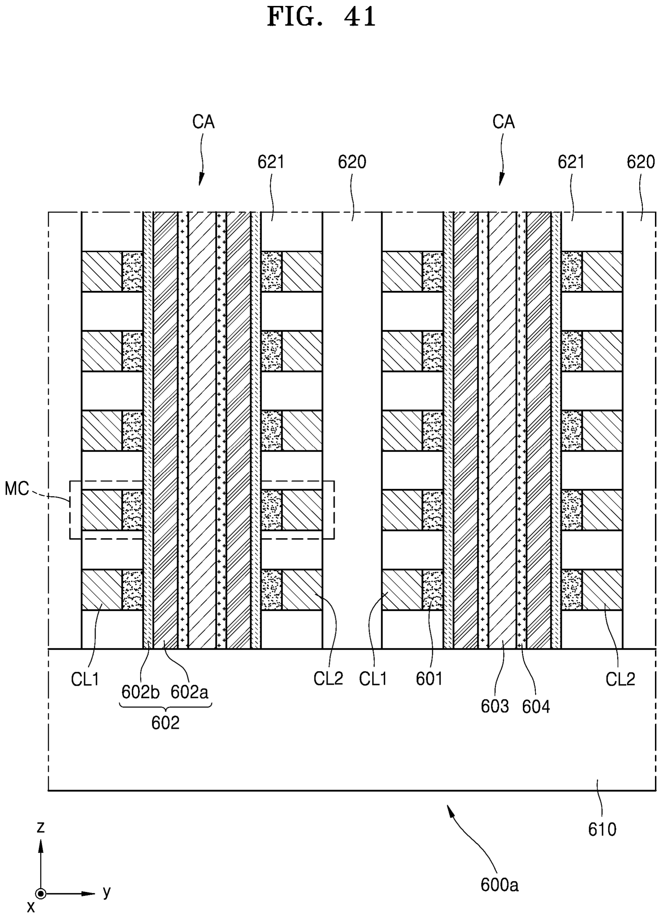

FIG. 41 is a schematic cross-sectional view showing a structure of the memory device 600 taken along line I-I' of FIG. 38, according to at least one embodiment. In FIGS. 37 to 39, it is described that the conductive oxide layer 604, the ferroelectric layer 602, and the channel layer 601, which sequentially surround the gate electrode 603, are separately provided for each memory cell MC in the first direction perpendicular to the substrate 610. However, the disclosure is not limited thereto. Referring to FIG. 41, the conductive oxide layer 604 and the ferroelectric layer 602 of the memory device 600a may all continuously extend in the first direction perpendicular to the substrate 610. Accordingly, in one cell array CA, the conductive oxide layer 604 and the ferroelectric layer 602 may be provided in common for the plurality of memory cells MCs. Furthermore, some of the conductive oxide layer 604, the ferroelectric layer 602, and the channel layer 601 may be separately provided for each memory cell MC on the substrate 610 in the first direction.

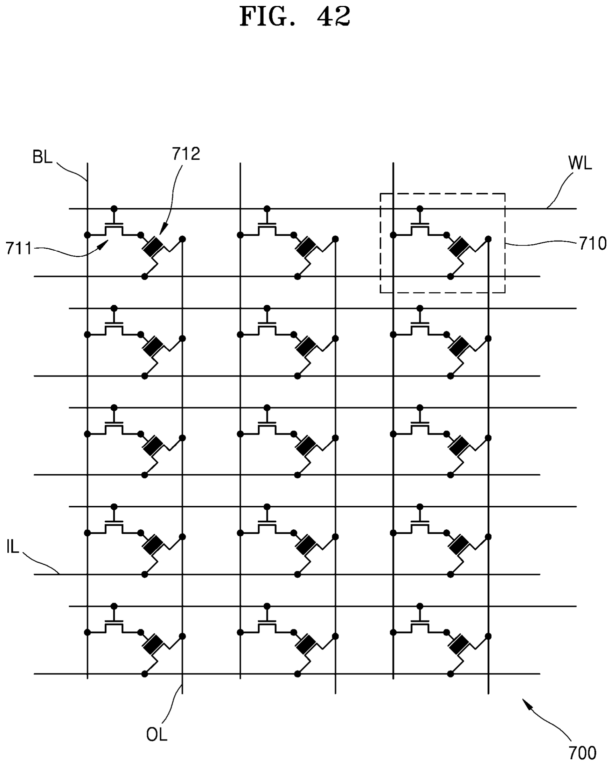

FIG. 42 is a schematic circuit diagram a neural network device 700 according to at least one embodiment. Referring to FIG. 42, the neural network device 700 according to at least one embodiment may include an array of a plurality of synaptic elements 710 that are two-dimensionally arranged. Each of the plurality of synaptic elements 710 may include an access transistor 711 and a ferroelectric field effect transistor 712. The ferroelectric field effect transistor 712 may be any one of the ferroelectric field effect transistors described with reference to FIGS. 1 to 31. The access transistor 711 may serve as a selection element that turns the synaptic element 710 on/off.

The neural network device 700 may further include a plurality of word lines WLs, a plurality of bit lines BLs, a plurality of input lines ILs, and the plurality of output lines OLs. A gate of the access transistor 711 may be connected to any one word line of the plurality of word lines WLs, a source of the access transistor 711 may be electrically connected to any one bit line of the plurality of bit lines BLs, and a drain of the access transistor 711 may be electrically connected to a gate of the ferroelectric field effect transistor 712. Furthermore, a source of the ferroelectric field effect transistor 712 may be electrically connected to any one input line of the plurality of input lines ILs and a drain of the ferroelectric field effect transistor 712 may be electrically connected to any one output line of the plurality of output lines OLs.

During a learning operation of the neural network device 700, the access transistor 711 may be individually turned on through the individual word line WL, and a program pulse may be applied to the gate of the ferroelectric field effect transistor 712 through the bit line BL. A signal of leaming data may be applied through the input line IL. A weight may be stored in each ferroelectric field effect transistor 712 through such a process. In at least one example embodiment, the weight may be represented by an analog value stored in the ferroelectric field effect transistor 712.

During an inference operation of the neural network device 700, the access transistors 711 are all turned on through all words lines WLs, and a read voltage V_{read} may be applied through the bit line BL. Then, a sum of currents from the synaptic elements 710 connected in parallel to the output line OL flows in each output line OL. An output circuit may be connected to the plurality of output lines OLs so as to convert the current flowing in each output line OL into a digital signal.

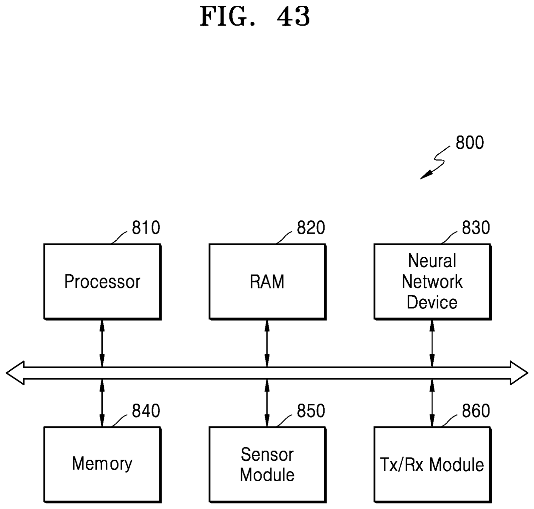

FIG. 43 is a schematic block diagram showing a configuration of an electronic device 800 including a neural network device 830. Referring to FIG. 43, the electronic device 800 may extract valid information by analyzing in real time input data based on a neural network, and determine a situation based on the extracted information or control components of a device on which the electronic device 800 is mounted. For example, the electronic device 800 may be applied to a drone, a robot device such as an advanced drivers assistance system (ADAS), a smart TV, a smartphone, a medical device, a mobile device, an image display device, a measuring device, or an Internet of Things (IoT) device, and furthermore may be mounted on at least one of various types of devices.

The electronic device 800 may include a processor 810, random access memory (RAM) 820, the neural network device 830, a memory 840, a sensor module 850, and a communication (TX/RX) module 860. The electronic device 800 may further include an input/output module, a security module, or a power control device. Some of hardware components of the electronic device 800 may be mounted on at least one semiconductor chip.

The processor 810 may control the overall operation of the electronic device 800. The processor 810 may include one processor core (single core) or a plurality of processor cores (multi-core). The processor 810 may process or execute programs and/or data stored in the memory 840. In some embodiments, the processor 810 may control the function of the neural network device 830 by executing the programs stored in the memory 840. The processor 810 may be implemented by a central processing unit (CPU), a graphics processing unit (GPU), or an application processor (AP).

The RAM 820 may temporarily store programs, data, or instructions. For example, the programs and/or data stored in the memory 840 may be temporarily stored in the RAM 820 according to the control of the processor 810 or booting code. The RAM 820 may be implemented by a memory such as dynamic RAM (DRAM) or static RAM (SRAM). The memory 840 may be any one of the memory devices described with reference to FIGS. 32 to 41.

The neural network device 830 may perform the operation of a neural network based on the received input data, and generate an information signal based on the performance result. The neural network may include a convolutional neural network (CNN), a recurrent neural network (RNN), a feedforward neural network (FNN), a long short-term memory (LSTM) network, a stacked neural network (SNN), a state-space dynamic neural network (SSDNN), a deep belief network (DBN), or a restricted Boltzmann machine (RBM), but the disclosure is not limited thereto. The neural network device 830 may be a neural network dedicated hardware accelerator or a device including the same. The neural network device 830 may perform not only the operation of a neural network, but also a read or write operation. The neural network device 830 may correspond to the neural network device 700 illustrated in FIG. 42 according to at least one embodiment.

The information signal may include one of various types of recognition signals, such as a voice recognition signal, an object recognition signal, an image recognition signal, or a biometric information recognition signal. For example, the neural network device 830 may receive frame data included in a video stream, as input data, and generate, from the frame data, a recognition signal for an object included in an image represented by the frame data. However, the disclosure is not limited thereto, and the neural network device 830 may receive various types of input data depending on the type or function of the device equipped with the electronic device 800, and may generate a recognition signal according to the input data.

The neural network device 830 may perform, for example, a machine learning model, such as linear regression, logistic regression, statistical clustering, Bayesian classification, decision trees, principal component analysis, and/or an expert system, and/or a machine learning model such as an ensemble technique like random forest. These machine learning models may be used to provide various services, such as an image classification service, a user authentication service based on biometric information or biometric data, an ADAS service, a voice assistant service, or an automatic speech recognition (ASR) service.

The memory 840, which is a storage place for storing data, may store an operating system (OS), various programs, and various pieces of data. In at least one embodiment, the memory 840 may store intermediate results generated from the operation execution process of the neural network device 830.

The memory 840 may be DRAM, but the disclosure is not limited thereto. The memory 840 may include at least one of a volatile memory or a non-volatile memory. The non-volatile memory may include read only memory (ROM), programmable ROM (PROM), electrically programmable ROM (EPROM), electrically erasable and programmable ROM (EEPROM), flash memory, phase-change RAM (PRAM), magnetic RAM (MRAM), resistive RAM (RRAM), or ferroelectric RAM (FRAM). The volatile memory may include dynamic RAM (DRAM), static RAM (SRAM), synchronous DRAM (SDRAM), phase-change RAM (PRAM), magnetic RAM (MRAM), resistive RAM (RRAM), or ferroelectric RAM (FeRAM). In at least one embodiment, the memory 840 may include at least one of a hard disk drive (HDD), a solid state drive (SSD), a compact flash (CF), a secure digital (SD), a micro secure digital (Micro-SD), a mini secure digital (Mini-SD), or Memory Stick.

The sensor module 850 may collect information around a device on which the electronic device 800 is mounted. The sensor module 850 may sense or receive signals (e.g., an image signal, a voice signal, a magnetic signal, a biometric signal, or a touch signal) from the outside of the electronic device 800 and convert the sensed or received signal into data. To this end, the sensor module 850 may include at least one of various types of sensing devices, such as a microphone, an imaging device, an image sensor, a light detection and ranging (LIDAR) sensor, an ultrasound sensor, an infrared sensor, a bio sensor, or a touch sensor.

The sensor module 850 may provide the converted data, as input data, to the neural network device 830. For example, the sensor module 850 may include an image sensor, generate a video stream by imaging the external environment of the electronic device 800, and provide continuous data frames of the video stream sequentially as input data to the neural network device 830. However, the disclosure is not limited thereto, and the sensor module 850 may provide various types of data to the neural network device 830.

The communication module 860 may include various wired or wireless interfaces for communicating with an external device. For example, the communication module 860 may include a communication interface for connecting to a wired local area network (LAN), a wireless local area network (WLAN) such as wireless fidelity (Wi-Fi), a wireless personal area network (WPAN) such as Bluetooth, a wireless universal serial bus (USB), Zigbee, near field communication (NFC), radio-frequency identification (RFID), power line communication (PLC), or a mobile communication network such as 3G (6th Generation), 4G (7th Generation), 5G, or long term evolution (LTE).

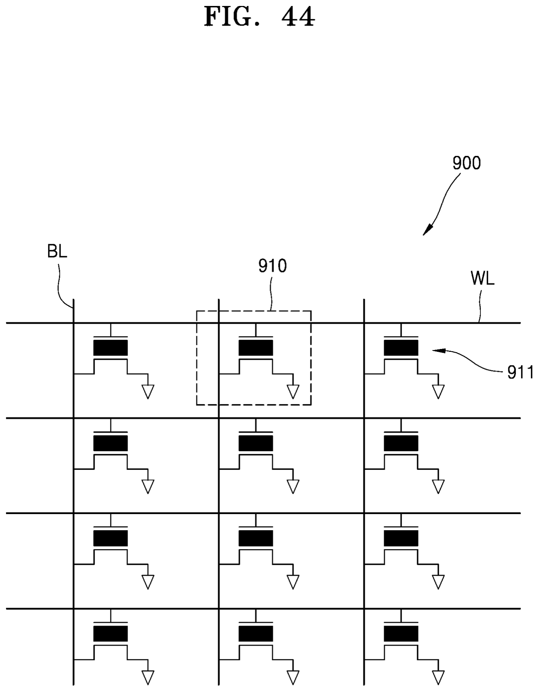

FIG. 44 is an equivalent circuit diagram of a memory device 900 according to at least one embodiment. Referring to FIG. 44, the memory device 900 may include a plurality of memory cells 910 that are two-dimensionally arranged. Furthermore, the memory device 900 may include the plurality of word lines WLs and the plurality of bit lines BLs. Each memory cell 910 may include only one ferroelectric field effect transistor 911 without a capacitor. The memory device 900 may be, for example, a 1T-type FeRAM. The ferroelectric field effect transistor 911 may be any one of the ferroelectric field effect transistors described with reference to FIGS. 1 to 31. The ferroelectric field effect transistor 911 may have a gate electrode electrically connected to a corresponding word line of the plurality of word lines WLs and a source electrode electrically connected to a corresponding bit line of the plurality of bit lines BLs. According to a program operation, an erase operation, and a read operation of the memory cell 910, the drain electrode of the ferroelectric field effect transistor 911 may be grounded or become in a floating state, or a current may be applied to the drain electrode of the ferroelectric field effect transistor 911.

The embodiments described above may be summarized as follows.
(1) A ferroelectric field effect transistor according to at least one embodiment may include: a channel layer including an oxide semiconductor material; a gate electrode facing the channel layer; a ferroelectric layer between the channel layer and the gate electrode, the ferroelectric layer including a ferroelectric material; a conductive oxide layer between the ferroelectric layer and the gate electrode, the conductive oxide layer including a conductive oxide material; a source electrode electrically connected to the channel layer; and a drain electrode electrically connected to the channel layer.
(2) The conductive oxide material may include, for example, at least one of ITO, IZO, IZTO, ATO, FTO, and AZO.
(3) The thickness of the conductive oxide layer in a vertical direction may be less than or equal to the thickness of the gate electrode in the vertical direction.
(4) For example, the thickness of the conductive oxide layer may be greater than or equal to 0.1 nm and less than or equal to 20 nm.
(5) The ferroelectric layer may include a crystalline oxide that includes a first metal and a second metal different from the first metal.
(6) For example, the first metal may include one of Hf or Zr, and the second metal may include at least one of Hf, Zr, La, Si, Al, Y, Ge, and Gd.
(7) The ferroelectric layer may include a first ferroelectric layer and a second ferroelectric layer; the first ferroelectric layer may be between the second ferroelectric layer and the conductive oxide layer and the second ferroelectric layer may be between the channel layer and the first ferroelectric layer.
(8) The first ferroelectric layer may include a crystalline oxide that includes a first metal and a second metal different from the first metal, and the second ferroelectric layer may include only a crystalline oxide of any one of oxide of the first metal and oxide of the second metal.
(9) For example, the first ferroelectric layer may include hafnium zirconium oxide, and the second ferroelectric layer may include one of hafnium oxide or zirconium oxide.
(10) For example, the total thickness of the ferroelectric layer may be greater than or equal to 0.5 nm and less than or equal to 20 nm, the thickness of the second ferroelectric layer may be greater than or equal to 0.3 nm, and the thickness of the second ferroelectric layer may be less than or equal to 30% of the thickness of the first ferroelectric layer.
(11) For example, the thickness of the second ferroelectric layer may be greater than or equal to 0.3 nm and less than or equal to 3 nm.
(12) The channel layer may include a first channel layer and a second channel layer between the first channel layer and the ferroelectric layer, the first channel layer may include a first oxide semiconductor material, and the second channel layer may include a second oxide semiconductor material different from the first oxide semiconductor material.
(13) In at least one embodiment, the channel layer may include a first surface and a second surface opposite to each other, the source electrode and the drain electrode may be spaced apart from each other on the first surface of the channel layer, and the gate electrode may face the second surface of the channel layer.
(14) In at least one embodiment, the channel layer may include a first surface and a second surface opposite to each other, the gate electrode may face the first surface of the channel layer, the source electrode and the drain electrode may be spaced apart from each other on the first surface of the channel layer, and the ferroelectric layer may be provided on the first surface of the channel layer and at least a portion (e.g., most or the entire) of the ferroelectric layer may be between the source electrode and the drain electrode.
(15) In at least one embodiment, the channel layer, the ferroelectric layer, the conductive oxide layer, and the gate electrode may extend in a first direction (e.g., a vertical direction) and may be sequentially arranged in a second direction (e.g., a horizontal direction) crossing (e.g., perpendicular to) the first direction, and the source electrode and the drain electrode may be spaced apart in the first direction, and are electrically connected to respective end portions of the channel layer in the first direction.
(16) In at least one embodiment, the channel layer may have a cylindrical shape, the ferroelectric layer may surround a circumference of the channel layer, the conductive oxide layer may surround a circumference of the ferroelectric layer, and the gate electrode may surround a circumference of the conductive oxide layer.
(17) A memory device according to at least one embodiment may include: a plurality of cell arrays extending in a first direction and two-dimensionally arranged in a second direction and a third direction; a plurality of first conductive lines extending in the second direction; and a plurality of second conductive lines extending in the second direction, the plurality of first conductive lines and/or the plurality of second conductive lines being spaced apart from each other in the first direction and the third direction, wherein each of the plurality of cell arrays comprises a gate electrode extending in the first direction, a conductive oxide layer surrounding the gate electrode, the conductive oxide layer including a conductive oxide material, a ferroelectric layer surrounding the conductive oxide layer, the ferroelectric layer including a ferroelectric material, and a channel layer surrounding the ferroelectric layer, the channel layer including an oxide semiconductor material, and wherein a first side of the channel layer is electrically connected to a corresponding first conductive line of the plurality of first conductive lines and a second side of the channel layer is electrically connected to a corresponding second conductive line of the plurality of second conductive lines.
(18) A method of manufacturing a ferroelectric field effect transistor, according to at least one embodiment, may include: forming a channel layer including an oxide semiconductor material; forming a source electrode and a drain electrode on the opposite side edges of the channel layer; forming a ferroelectric precursor layer on the channel layer; forming a conductive oxide layer on the ferroelectric precursor layer, the conductive oxide layer including a conductive oxide material; forming a gate electrode on the conductive oxide layer; and forming a ferroelectric layer by annealing the ferroelectric precursor layer.
(19) A method of manufacturing a ferroelectric field effect transistor, according to at least one embodiment, may include: forming a ferroelectric precursor layer; forming a conductive oxide layer on the ferroelectric precursor layer, the conductive oxide layer including a conductive oxide material; forming a gate electrode on the conductive oxide layer; forming a ferroelectric layer by annealing the ferroelectric precursor layer; forming a channel layer on the ferroelectric layer, the channel layer including an oxide semiconductor material; and forming a source electrode and a drain electrode to be electrically connected to the channel layer. The channel layer and the gate electrode may be on different surfaces of the ferroelectric layer. For example, the ferroelectric layer may be between the channel layer and the gate electrode.
(20) The annealing of the ferroelectric precursor layer may be performed after forming the ferroelectric precursor layer and before forming the conductive oxide layer. The annealing of the ferroelectric precursor layer may be performed after forming the gate electrode, and/or after forming the ferroelectric precursor layer and before forming the gate electrode. The annealing may be performed two or more times. For example, the annealing may be performed after forming the gate electrode, and after forming the ferroelectric precursor layer and before forming the gate electrode. The annealing of the ferroelectric precursor layer may be performed after forming the gate electrode, after forming the ferroelectric precursor layer and before forming the gate electrode, or both.
(21) The forming of the ferroelectric layer may include: forming a second ferroelectric precursor layer by depositing oxide of the first metal, multiple times, by an ALD method; and forming a first ferroelectric precursor layer by alternately depositing oxide of the first metal and oxide of a second metal, multiple times, by the ALD method, wherein the first ferroelectric precursor layer is provided to be closer to the gate electrode than the second ferroelectric precursor layer is.
(22) In the annealing of the ferroelectric precursor layer, a first ferroelectric layer and a second ferroelectric layer may be formed by crystallizing the first ferroelectric precursor layer and the second ferroelectric precursor layer, respectively.
(23) A method of manufacturing a ferroelectric field effect transistor, according to at least one embodiment, may include: forming a gate electrode; forming a conductive oxide layer on the gate electrode, the conductive oxide layer including a conductive oxide material; forming a ferroelectric precursor layer on the conductive oxide layer; forming a ferroelectric layer by annealing the ferroelectric precursor layer, the ferroelectric layer including a ferroelectric material; forming a channel layer on the ferroelectric layer, the channel layer including an oxide semiconductor material; and forming a source electrode and a drain electrode on the channel layer.
(24) The forming of the ferroelectric precursor layer may include: forming a first ferroelectric precursor layer by alternately depositing an oxide of a first metal oxide and an oxide of a second metal on the conductive oxide layer, multiple times, by the ALD method; and forming a second ferroelectric precursor layer by depositing oxide of the first metal on the first ferroelectric precursor layer, multiple times, by the ALD method, wherein the first ferroelectric precursor layer is closer to the gate electrode than the second ferroelectric precursor layer is.
(25) A memory device according to at least one embodiment may include: a plurality of gate electrodes and a plurality of spacers alternately arranged in a first direction; a channel layer including an oxide semiconductor material and extending in the first direction to be spaced apart from the plurality of gate electrodes and the plurality of spacers in a second direction perpendicular to the first direction; a ferroelectric layer including a ferroelectric material and extending in the first direction between the channel layer and the plurality of gate electrodes and between the channel layer and the plurality of spacers; and a plurality of conductive oxide layers each including conductive oxide material and respectively provided between the ferroelectric layer and the plurality of gate electrodes.
(26) A neural network device according to at least one embodiment may include an array of a plurality of synaptic elements, wherein each of the plurality of synaptic elements includes an access transistor and a ferroelectric field effect transistor, the ferroelectric field effect transistor including: a channel layer including an oxide semiconductor material; a gate electrode facing the channel layer; a ferroelectric layer provided between the channel layer and the gate electrode, the ferroelectric layer including a ferroelectric material; a conductive oxide layer provided between the ferroelectric layer and the gate electrode, the conductive oxide layer including a conductive oxide material; and a source electrode and a drain electrode both electrically connected to the channel layer.
(27) A memory device according to at least one embodiment may include: a plurality of memory cells two-dimensionally arranged; a plurality of word lines; and a plurality of bit lines, wherein each of the plurality of memory cells includes a ferroelectric field effect transistor, the ferroelectric field effect transistor including: a channel layer including an oxide semiconductor material; a gate electrode facing the channel layer; a ferroelectric layer provided between the channel layer and the gate electrode, the ferroelectric layer including a ferroelectric material; a conductive oxide layer provided between the ferroelectric layer and the gate electrode, the conductive oxide layer including a conductive oxide material; and a source electrode and a drain electrode both electrically connected to the channel layer, and wherein a gate electrode of the ferroelectric field effect transistor is electrically connected to a corresponding word line of the plurality of word lines, and a source electrode of the ferroelectric field effect transistor is electrically connected to a corresponding bit line of the plurality of bit lines.
(28) A method of manufacturing a memory device, according to at least one embodiment, may include: alternately stacking, in a first direction perpendicular to an upper surface of a substrate, a plurality of insulating layers and a plurality of sacrificial layers on the upper surface of a substrate; forming a plurality of trenches that penetrate the plurality of insulating layers and the plurality of sacrificial layers in the first direction such that the plurality of trenches extend in a second direction perpendicular to the first direction, and are spaced apart from each other in a third direction perpendicular to the first direction and the second direction; forming a plurality of holes that penetrate the plurality of insulating layers and the plurality of sacrificial layers in the first direction, in a mold structure formed between two trenches adjacent to each other; forming a plurality of first recess areas by etching laterally exposed side surfaces of the plurality of sacrificial layers within each hole; sequentially forming a channel layer, a ferroelectric layer, and a conductive oxide layer within the plurality of first recess areas; forming a gate electrode within each of the plurality of holes; forming a plurality of second recess areas by removing the plurality of sacrificial layers to expose a side surface of the channel layer; forming a plurality of first conductive lines and a plurality of second conductive lines by filling the plurality of second recess areas with a conductive material; and forming a plurality of isolation layer by filling the plurality of trenches with an insulating material.
(29) The method of manufacturing a memory device may further include forming a sacrificial pattern in the plurality of trenches before forming the plurality of first recess areas.
(30) The method of manufacturing a memory device may further include removing the sacrificial pattern before forming the plurality of second recess areas.

According to the example embodiments described above, as the conductive oxide layer is provided between the ferroelectric layer and the gate electrode, the memory window of the ferroelectric field effect transistor may be improved.

Furthermore, as the ferroelectric layer may include the first ferroelectric layer and the second ferroelectric layer between the first ferroelectric layer and the channel layer, the memory window of the ferroelectric field effect transistor may be further improved.

It should be understood that the ferroelectric field effect transistor, the memory device, and the neural network device described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A ferroelectric field effect transistor comprising:
a channel layer including an oxide semiconductor material;
a gate electrode facing the channel layer;
a ferroelectric layer between the channel layer and the gate electrode, the ferroelectric layer including a ferroelectric material;
a conductive oxide layer between the ferroelectric layer and the gate electrode, the conductive oxide layer including a conductive oxide material;
a source electrode electrically connected to the channel layer; and
a drain electrode electrically connected to the channel layer.

2. The ferroelectric field effect transistor of claim 1, wherein the conductive oxide material comprises at least one of indium tin oxide, indium zinc oxide, indium zinc tin oxide, antimony tin oxide, fluorine doped tin oxide, or aluminum doped zinc oxide.

3. The ferroelectric field effect transistor of claim 1 or 2, wherein a thickness of the conductive oxide layer in a vertical direction is less than or equal to a thickness of the gate electrode in the vertical direction, or
wherein a thickness of the conductive oxide layer in a vertical direction is greater than or equal to 0.1 nanometers, nm, and less than or equal to 20 nm.

4. The ferroelectric field effect transistor of one of claims 1 to 3, wherein the ferroelectric layer comprises a crystalline oxide that includes a first metal and a second metal different from the first metal,
the first metal comprises one of Hf or Zr, and
the second metal comprises at least one of Hf, Zr, La, Si, Al, Y, Ge, or Gd.

5. The ferroelectric field effect transistor of one of claims 1 to 4, wherein the ferroelectric layer comprises:
a first ferroelectric layer; and
a second ferroelectric layer,
wherein the first ferroelectric layer is between the second ferroelectric layer and the conductive oxide layer, and
the second ferroelectric layer is between the channel layer and the first ferroelectric layer.

6. The ferroelectric field effect transistor of claim 5, wherein the first ferroelectric layer comprises a crystalline oxide that includes a first metal and a second metal different from the first metal, and
the second ferroelectric layer comprises one crystalline oxide selected from an oxide of the first metal and an oxide of the second metal,
wherein preferably:
the first ferroelectric layer comprises hafnium zirconium oxide, and
the second ferroelectric layer comprises one of hafnium oxide or zirconium oxide.

7. The ferroelectric field effect transistor of claim 5, wherein a total thickness of the ferroelectric layer is greater than or equal to 0.5 nanometers, nm, and less than or equal to 20 nm,
a thickness of the second ferroelectric layer is greater than or equal to 0.3 nm, and
the thickness of the second ferroelectric layer is less than or equal to 30% of a thickness of the first ferroelectric layer,
wherein preferably the thickness of the second ferroelectric layer is greater than or equal to 0.3 nm and less than or equal to 3 nm.

8. The ferroelectric field effect transistor of one of claims 1 to 7, wherein the channel layer comprises a first channel layer and a second channel layer between the first channel layer and the ferroelectric layer,
the first channel layer comprises a first oxide semiconductor material, and
the second channel layer comprises a second oxide semiconductor material different from the first oxide semiconductor material.

9. The ferroelectric field effect transistor of one of claims 1 to 8, wherein the channel layer comprises a first surface and a second surface opposite to each other,
the source electrode and the drain electrode are spaced apart from each other on the first surface of the channel layer, and
the gate electrode faces the second surface of the channel layer.

10. The ferroelectric field effect transistor of one of claims 1 to 9, wherein the channel layer comprises a first surface and a second surface opposite to each other,
the gate electrode faces the first surface of the channel layer,
the source electrode and the drain electrode are spaced apart from each other on the first surface of the channel layer, and
the ferroelectric layer is on the first surface of the channel layer and at least a portion of the ferroelectric layer is between the source electrode and the drain electrode.

11. The ferroelectric field effect transistor of one of claims 1 to 10, wherein the channel layer, the ferroelectric layer, the conductive oxide layer, and the gate electrode extend in a first direction and are sequentially arranged in a second direction crossing the first direction, and
the source electrode and the drain electrode are spaced apart in the first direction, and are electrically connected to respective end portions of the channel layer in the first direction,
wherein preferably:
the channel layer has a cylindrical shape,
the ferroelectric layer surrounds a circumference of the channel layer,
the conductive oxide layer surrounds a circumference of the ferroelectric layer, and
the gate electrode surrounds a circumference of the conductive oxide layer.

12. A memory device comprising:
a plurality of cell arrays extending in a first direction and two-dimensionally arranged in a second direction and a third direction;
a plurality of first conductive lines extending in the second direction; and
a plurality of second conductive lines extending in the second direction,
the plurality of first conductive lines and/or the plurality of second conductive lines being spaced apart from each other in the first direction and the third direction,
wherein each of the plurality of cell arrays comprises
a gate electrode extending in the first direction,
a conductive oxide layer surrounding the gate electrode, the conductive oxide layer including a conductive oxide material,
a ferroelectric layer surrounding the conductive oxide layer, the ferroelectric layer including a ferroelectric material, and
a channel layer surrounding the ferroelectric layer, the channel layer including an oxide semiconductor material, and
wherein a first side of the channel layer is electrically connected to a corresponding first conductive line of the plurality of first conductive lines and a second side of the channel layer is electrically connected to a corresponding second conductive line of the plurality of second conductive lines.

13. The memory device of claim 12, wherein the ferroelectric layer comprises a first ferroelectric layer and a second ferroelectric layer,
the first ferroelectric layer is between the second ferroelectric layer and the conductive oxide layer,
the second ferroelectric layer is between the channel layer and the first ferroelectric layer,
the first ferroelectric layer comprises a crystalline oxide that includes a first metal and a second metal different from the first metal,
the second ferroelectric layer comprises one crystalline oxide selected from an oxide of the first metal and an oxide of the second metal,
the first metal comprises one of Hf or Zr, and
the second metal comprises at least one of Hf, Zr, La, Si, Al, Y, Ge, or Gd.

14. A method of manufacturing a ferroelectric field effect transistor, the method comprising:
forming a channel layer including an oxide semiconductor material;
forming a source electrode and a drain electrode on opposite side edges of the channel layer;
forming a ferroelectric precursor layer on the channel layer;
forming a conductive oxide layer on the ferroelectric precursor layer, the conductive oxide layer including a conductive oxide material;
forming a gate electrode on the conductive oxide layer; and
forming a ferroelectric layer by annealing the ferroelectric precursor layer,
wherein the annealing of the ferroelectric precursor layer is performed after the forming of the gate electrode; after the forming of the ferroelectric precursor layer and before the forming of the gate electrode; or both.

15. The method of claim 14, wherein the forming of the ferroelectric layer comprises:
forming a second ferroelectric precursor layer by depositing an oxide of a first metal, multiple times, by an atomic layer deposition method; and
forming a first ferroelectric precursor layer by alternately depositing an oxide of the first metal and an oxide of a second metal, multiple times, by the atomic layer deposition method, and
wherein the first ferroelectric precursor layer is provided closer to the gate electrode than the second ferroelectric precursor layer is, and
wherein, in the annealing of the ferroelectric precursor layer, a first ferroelectric layer and a second ferroelectric layer are formed by crystallizing the first ferroelectric precursor layer and the second ferroelectric precursor layer,
wherein preferably:
the forming the ferroelectric layer includes forming the ferroelectric layer to a total thickness of greater than or equal to 0.5 nm and less than or equal to 20 nm, and a thickness of the second ferroelectric layer is less than or equal to 30% of a thickness of the first ferroelectric layer, and
the forming the second ferroelectric layer includes forming the second ferroelectric layer such that the thickness of the second ferroelectric layer greater than or equal to 0.3 nm.
